# EUROPÄISCHE PATENTSCHRIFT

(11) **EP 2 875 524 B1**
(45) Veröffentlichungstag und Bekanntmachung des Hinweises auf die Patenterteilung: **07.12.2016**
(21) Anmeldenummer: 13739143.9
(22) Anmeldetag: 11.07.2013
(51) Int. Cl.: H01L 21/683, H02N 13/00

(54) **ELEKTROADHÄSIONSGREIFER ZUM HALTEN VON WERKSTÜCKEN**
ELECTRO-ADHESION GRIPPER FOR HOLDING WORKPIECES
PRÉHENSEUR DE MAINTIEN DE PIÈCES PAR ADHÉSION ÉLECTRIQUE

(30) Priorität: 17.07.2012 DE 102012212465
(43) Veröffentlichungstag der Anmeldung: 27.05.2015
(73) Patentinhaber: Trumpf Werkzeugmaschinen GmbH + Co. KG, 71254 Ditzingen (DE)
(72) Erfinder: THIEL, Walter, 71409 Schwaikheim (DE); HEINZ, Alexander, 71665 Vaihingen an der Enz (DE)
(74) Vertreter: Kohler Schmid Möbus Patentanwälte
(86) Internationale Anmeldenummer: PCT/EP2013/002056
(87) Internationale Veröffentlichungsnummer: WO 2014/012638

(56) Entgegenhaltungen:
- GB-A- 1 352 715
- US-B1- 7 126 091

## Beschreibung

Die Erfindung betrifft einen Elektroadhäsionsgreifer zum Halten von Werkstücken, umfassend eine erste spiralförmige Elektrode mit mehreren Windungen und eine zweite spiralförmige Elektrode mit mehreren Windungen, wobei die beiden spiralförmigen Elektroden zumindest teilweise bifilar angeordnet sind.

Ein solcher Elektroadhäsionsgreifer ist aus der GB 1 352 715 A bekannt geworden.

Elektroadhäsionsgreifer werden dazu eingesetzt, Werkstücke an einer Adhäsionsfläche (Greiffläche) des Greifers festzuhalten, etwa zum Transport der Werkstücke in industriellen Produktionsprozessen, insbesondere verketteten Produktionsprozessen.

An der Adhäsionsfläche sind zwei Elektroden ausgebildet, an die eine Spannung angelegt wird, so dass zwischen den Elektroden ein starkes elektrisches Feld herrscht. Ein Werkstück, das an der Adhäsionsfläche anliegt, bleibt bei eingeschaltetem elektrischen Feld an der Adhäsionsfläche haften.

Aus der GB 1 352 715 A (Stevko) ist ein Elektroadhäsionsgreifer bekannt geworden, bei dem die beiden Elektroden mit ineinander greifenden, geraden Fingern ausgebildet sind. Bei einer alternativen Ausgestaltung sind die Elektroden als zwei ineinander geschachtelte Spiralen ausgebildet.

Elektroadhäsion eignet sich vor allem zum Festhalten von im Verhältnis zu ihren Oberflächen leichten Werkstücken, beispielsweise Blechen, da die wirkenden Kräfte (verglichen beispielsweise mit Sauggreifern oder Magnetgreifern) relativ klein sind.

Aus der WO 2008/070201 A2 (SRI International) sind Elektroadhäsionsgeräte mit verformbarer Adhäsionsfläche, insbesondere als Kletterhilfe zum Erklimmen einer rauen Wand, bekannt geworden. Neben rechenförmigen Elektroden werden auch aus konzentrischen Ringen aufgebaute Elektroden erwähnt. Weiterhin wird ein Hybridgreifer mit einer Saugglocke vorgeschlagen, an deren Umfang eine Elektroadhäsionsvorrichtung angeordnet ist, um eine Leckrate zu verringern und die Saugkräfte zu verstärken. Aus der WO 01/32114 A1 ist eine Hautgreifapparatur bekannt geworden, bei der die Haut eines Menschen als Elektrode gegen eine oder mehrere Elektroden der Apparatur geschaltet wird. In einer Variante als Vakuummassagegerät wird zusätzlich an zahlreichen Luftkanälen ein Vakuum angelegt.

Vor allem wenn Elektroadhäsion allein zum Ergreifen und Verbringen eines Werkstücks eingesetzt wird, und auf das Werkstück nur eine entsprechend geringe Kraft wirkt, sollte in verketteten Produktionsprozessen geprüft werden, ob das Ergreifen des Werkstücks gelungen ist und ob das Werkstück beim Verbringen verlorengegangen (abgefallen) ist. Zudem sollte geprüft werden, ob das Ablegen eines Werkstücks gelungen ist, da kapazitive Restladungen an den Elektroden bzw. dem Werkstück auch nach Abschalten der Spannung eine erhebliche verbleibende Adhäsionswirkung entfalten können.

Um das Abwerfen eines Werkstücks sicherzustellen, ist es bekannt, den Abwurfprozess bei einem Elektroadhäsionsgreifer mit einem Auswurfaktuator zu unterstützen, vgl. GB 2 354 111 A. Weiterhin ist es bekannt geworden, mit komplexen Schaltungen kapazitive Restladungen zu bestimmen und zu entladen, vgl. JP 2007-019524 A, JP 6244270 A, JP 10284583 A,
JP 11040661 A, so dass das Abwerfen zuverlässig gelingt; dieses Vorgehen ist jedoch in der Praxis aufwändig und schwierig.

Aus der DE 10 2010 040 686 B3 ist es bekannt geworden, bei einem Sauggreifer die Belegung mit einem Werkstück durch elektrische Messungen zu überwachen. Insbesondere kann durch ein ergriffenes, metallisches Werkstück ein elektrischer Kontakt geschlossen oder ein paralleler Strompfad eröffnet werden; ebenso wird vorgeschlagen, einen durch ein ergriffenes Werkstück bewirkten Anstieg der Induktivität in einer Leiterschleife nahe der Werkstückposition auszuwerten.

Um die Belegung eines Elektroadhäsionsgreifers zu überprüfen, könnte ein zusätzlicher Messstromkreis eingerichtet werden, was jedoch den Aufbau des Elektroadhäsionsgreifers verkomplizieren würde und den Elektroadhäsionsgreifer deutlich verteuern würde.

### Aufgabe der Erfindung

Der Erfindung liegt die Aufgabe zugrunde, einen Elektroadhäsionsgreifer vorzustellen, bei dem auf einfache Weise eine Überprüfung der Greiferbelegung möglich ist.

### Kurze Beschreibung der Erfindung

Diese Aufgabe wird gelöst durch einen Elektroadhäsionsgreifer der eingangs genannten Art, der dadurch gekennzeichnet ist, dass der Elektroadhäsionsgreifer ein Dioden-Bauteil aufweist, über das die spiralförmigen Elektroden miteinander verbunden sind,
wobei die Gesamtheit der über das Dioden-Bauteil in Serie verbundenen Teile der beiden spiralförmigen Elektroden eine nicht verschwindende Induktivität aufweist.

Der erfindungsgemäße Elektroadhäsionsgreifer gestattet, je nach Polarität einer an die Elektroden angelegten Spannung, die Nutzung einer Elektroadhäsionsgreiffunktion über die bifilar ausgebildeten Elektrodenabschnitte, in denen die Spannungsdifferenz zwischen den Elektroden die Ausbildung eines die Elektroadhäsion bewirkenden, elektrischen Feldes bewirkt, und die Nutzung einer Belegungsmessfunktion, bei der die nicht verschwindende Induktivität der über das Dioden-Bauteil seriell verschalteten Teile der Elektroden durch die Greiferbelegung beeinflusst wird.

Ein Dioden-Bauteil umfasst eine Diode oder mehrere, in Serie geschaltete Dioden (mit mehreren, in Serie geschalteten Elektroden kann eine höhere Durchbruchspannung eingerichtet werden). Das Dioden-Bauteil leitet oder sperrt abhängig von der Polarität einer anliegenden elektrischen Spannung. Für die Erfindung eignen sich insbesondere Suppressordioden, mit denen eine Durchbruchspannung im kV-Bereich gut erreichbar ist.

Die Elektroden verfügen typischerweise jeweils an einem Ende über einen Spannungsanschluss. Durch Anlegen einer Spannung in Sperrpolarität kann die Elektroadhäsionsfunktion der gesamten Elektroden (die hier im Wesentlichen als ein felderzeugender Kondensator wirken) genutzt werden; die Elektroden sind hierbei elektrisch voneinander isoliert. Bei Anlegen einer Spannung in Durchlasspolarität kann eine von der Induktivität der Gesamtheit der in Serie geschalteten Teile der Elektroden abhängige Messgröße zumindest grob bestimmt werden, um die Belegung des Elektroadhäsionsgreifers zu prüfen (die Elektrodenanordnung wirkt hier im Wesentlichen als Überwachungsspule oder Messspule). Typischerweise steigt die Induktivität bei ergriffenem Werkstück deutlich an, was beispielsweise über das Ladeverhalten (bzw. Steigung der U-I-Kennlinie) der Elektroden leicht und schnell festgestellt werden kann.

Die Induktivität der besagten Gesamtheit hängt von der Fläche und der Anzahl der an der Serienschaltung beteiligten Windungen (bzw. Windungsteile) der beiden Elektroden ab, wobei die Windungen der ersten Elektrode und der zweiten Elektrode mit unterschiedlichem Vorzeichen beitragen. Um eine nichtverschwindende Induktivität der Gesamtheit zu erreichen, unterscheiden sich daher erfindungsgemäß die Fläche und/oder die Anzahl der an der Serienschaltung beteiligten Windungen (bzw. Windungsteile) der beiden Elektroden. Typischerweise beträgt die besagte nicht verschwindende Induktivität betragsmäßig wenigstens 5%, bevorzugt wenigstens 10%, und besonders bevorzugt wenigstens 20% der Induktivität derjenigen (vollständigen) spiralförmigen Elektrode mit der betragsmäßig größeren Induktivität. Durch eine größere, nicht verschwindende Induktivität wird die Empfindlichkeit bei der Belegungsmessung verbessert.

Die beiden spiralförmigen Elektroden verlaufen zumindest teilweise bifilar (ineinander geschachtelt und nebeneinander liegend). Zwischen benachbarten Elektrodenabschnitten kann dann, wenn sich die Elektroden auf unterschiedlichem elektrischen Potential befinden, ein elektrisches Feld über den Zwischenraum zwischen den Elektrodenabschnitten errichtet werden. Durch den spiralförmigen Aufbau hat das elektrische Feld innerhalb der Fläche, in der die Elektroden verlaufen, keine Vorzugsrichtung, und ein guter Halt von Werkstücken ist in allen Orientierungen möglich. Die spiralförmigen Elektroden können jeweils insbesondere vom Typus einer logarithmischen Spirale, einer archimedischen Spirale oder einer fermatschen Spirale, oder auch einer frei gewählten Spirale mit im Wesentlichen schneckenförmig verlaufenden Windungen sein. Man beachte, dass eine Spirale erfindungsgemäß auch unrund (insbesondere eckig) oder auch nicht-planar (insbesondere schraubenartig oder helixartig) verlaufen kann; im Rahmen der Erfindung sind jedoch die beiden Elektroden bevorzugt flach ausgebildet.

Der erfindungsgemäße Elektroadhäsionsgreifer wird bevorzugt mit einer elektronischen Steuereinrichtung betrieben, die dazu ausgebildet ist, zum Ergreifen und Halten eines Werkstücks eine Wechselspannung an die Elektroden anzulegen, und weiterhin in vorgegebenen Situationen (etwa nach einem vorgesehenen Ergreifen oder Ablegen eines Werkstücks, oder auch in vorgegebenen Zeitintervallen bei gehaltenem Werkstück) die Greiferbelegung zu überprüfen. Ein erfindungsgemäßer Elektroadhäsionsgreifer kann weiterhin zusammen mit weiteren Elektroadhäsionsgreifern an einem gemeinsamen Rahmen befestigt sein, insbesondere um ein Werkstück mit mehreren Elektroadhäsionsgreifern gleichzeitig zu handhaben. Ein erfindungsgemäßer Elektroadhäsionsgreifer kann insbesondere in industriellen Produktions- und Bearbeitungsprozessen, bevorzugt bei verketteten Prozessen, zum Transport von Werkstücken wie Blechen eingesetzt werden.

### Bevorzugte Ausführungsformen der Erfindung

Bei einer vorteilhaften Ausführungsform des erfindungsgemäßen Elektroadhäsionsgreifers ist vorgesehen, dass das Dioden-Bauteil zwei direkt benachbarte Teilabschnitte der beiden Elektroden miteinander verbindet. Zwischen den direkt benachbarten Teilabschnitten der beiden Elektroden liegen (insbesondere in radialer Richtung) keine weiteren Teilabschnitte irgendeiner der beiden Elektroden. Bei dieser Ausführungsform können Kreuzungen von Leiterbahnen der Elektroden und des Dioden-Bauteils (die einen mehrschichtigen Aufbau erfordern würden) vermieden werden, was den Aufbau des Elektroadhäsionsgreifers erheblich vereinfacht.

Bevorzugt ist eine Weiterbildung dieser Ausführungsform, bei der das Dioden-Bauteil eine von außen gezählt n-te Windung einer der beiden Elektroden mit einer von außen gezählt n+1-ten Windung der anderen Elektrode miteinander verbindet, mit n ∈ IN und n ≥ 1, bevorzugt wobei n = 1. Dadurch kann bei Elektroden mit im Wesentlichen an der gleichen Umfangsposition (bei gleichem Drehwinkel) eingerichteten Spannungsanschlüssen auf einfache Weise eine um eins verschiedene Windungszahl der an der Serienschaltung beteiligten Windungen der beiden Elektroden eingerichtet werden, bei n=1 sogar mit einer maximalen Fläche der Differenzwindung, wobei gleiche Gesamtwindungszahlen der beiden Elektroden (und damit eine große Elektroadhäsionsfläche) eingerichtet werden können.

Bevorzugt ist weiterhin eine Weiterbildung, bei der die beiden spiralförmigen Elektroden jeweils an ihrem von einem Spannungsanschluss entfernten Ende über das Dioden-Bauteil verbunden sind, insbesondere wobei die beiden spiralförmigen Elektroden jeweils an ihrem inneren Ende über das Dioden-Bauteil verbunden sind. Im Bereich der Elektrodenenden kann das Dioden-Bauteil besonders einfach angeordnet werden, und die Beabstandung der Elektroden im bifilaren Bereich wird durch die Größe des Dioden-Bauteils kaum beeinträchtigt, auch wenn das Dioden-Bauteil in der Ebene der Elektroden liegt. Allerdings müssen ungleiche Gesamtwindungszahlen der beiden Elektroden (die die effektive Elektroadhäsionsfläche verkleinern) und/oder ungleiche Flächenüberdeckungen der Elektroden (die meist nur einen geringen Induktivitätsunterschied der Elektroden ermöglichen) hingenommen werden.

Besonders bevorzugt ist eine Ausführungsform, bei der zumindest eine der beiden Elektroden beabstandet von ihrem von einem Spannungsanschluss entfernten Ende mit dem Dioden-Bauteil verbunden ist,
insbesondere wobei die andere Elektrode mit ihrem von einem Spannungsabschluss entfernten Ende mit dem Dioden-Bauteil verbunden ist. Diese Ausführungsform ermöglicht es, in Durchgangspolarität einen vom Spannungsanschluss entfernten Teil einer Elektrode aus der Serienschaltung des Dioden-Bauteils herauszunehmen, und dadurch die Ungleichheit der Beiträge der beiden Elektroden zur Induktivität der Gesamtheit der an der Serienschaltung beteiligten Teile der Elektroden einzurichten oder zu vergrößern. Der herausgenommene Teil kann jedoch grundsätzlich voll zur Elektroadhäsionsfunktion in Sperrpolarität beitragen. Diese Ausführungsform kann insbesondere mit gleichen Gesamtwindungszahlen oder auch gleichen Flächenüberdeckungen der beiden Elektroden eingerichtet werden, so dass ein großflächiger, effizienter Elektroadhäsionsgreifer mit hoher Induktivität für eine einfache Belegungsmessung eingerichtet werden kann. Typischerweise wird bei dieser Ausführungsform aber eine Verbindung zwischen nicht direkt benachbarten Teilabschnitten der Elektroden eingerichtet, was Kreuzungen von Leiterbahnen bedingt, wodurch der Aufbau des Elektroadhäsionsgreifers etwas komplexer wird.

Bei einer besonders bevorzugten Ausführungsform ist die Anzahl der Windungen der ersten spiralförmigen Elektrode und der zweiten spiralförmigen Elektrode, die über das Dioden-Bauteil in Serie miteinander verbunden sind, ungleich. Dies ist eine einfache und sehr effiziente Maßnahme, um eine ausreichende Induktivität der Gesamtheit der über die Diode verbunden Teile der beiden Elektroden sicherzustellen. Hierfür kann beispielsweise eine der Elektroden (verglichen mit der anderen Elektrode) radial außerhalb und/oder radial innerhalb der anderen Elektrode zusätzliche Windungen aufweisen, wobei in der Regel die Elektroden jeweils endseitig über das Dioden-Bauteil verbunden werden. Ebenso ist es möglich, an zwei Elektroden mit typischerweise gleicher Gesamtwindungszahl (Windungsanzahl) mit dem Dioden-Bauteil bei unterschiedlichen Windungen (etwa auf der von außen gezählt ersten und vierten Windung) zu kontaktieren. Alternativ zu dieser Ausführungsform kann auch eine gleiche Anzahl von Windungen der beiden Spulen über das Dioden-Bauteil seriell miteinander verbunden sein (wobei in der Regel auch die Gesamtwindungszahlen der Elektroden gleich sind); in diesem Fall sollten sich die von diesen Windungen der beiden Spulen jeweils überdeckten Flächen deutlich unterscheiden, um eine ausreichend große Induktivität sicherzustellen.

Bei einer vorteilhaften Ausführungsform bleibt der radiale Abstand der Elektroden dort, wo die Elektroden bifilar angeordnet sind, mit dem Spiralradius konstant. Dadurch kann eine homogene Kraftverteilung des Elektroadhäsionsgreifers erreicht werden; Feldspitzen oder gar Spannungsdurchschläge werden vermieden.

Bei einer alternativen, ebenfalls vorteilhaften Ausführungsform ist der radiale Abstand der Elektroden dort, wo die Elektroden bifilar angeordnet sind, mit dem Spiralradius veränderlich. Dadurch kann die Kraftverteilung des Elektroadhäsionsgreifers gezielt beeinflusst werden. Beispielsweise kann der radiale Abstand radial nach außen verringert werden, um dort über eine höhere elektrische Feldstärke eine höhere Kraft zu erreichen (etwa um das Abdichten einer Dichtlippe einer zusätzlichen Sauggreiferfunktion zu unterstützen). Ebenso kann eine Differenz in der Flächenüberdeckung der beiden spiralförmigen Elektroden oder einer ihrer Windungen gezielt verändert werden, um die Gesamtinduktivität der durch das Dioden-Bauteil in Serie geschalteten Teile der beiden Elektroden zu vergrößern.

Bevorzugt ist weiterhin eine Ausführungsform, die vorsieht, dass die erste spiralförmige Elektrode zumindest im Wesentlichen in einer ersten Ebene verläuft, und die zweite spiralförmige Elektrode zumindest im Wesentlichen in einer zweiten Ebene verläuft, und dass die Ebenen zusammenfallen oder parallel in einem maximalen Abstand von 3,0 mm, bevorzugt in einem maximalen Abstand von 2,0 mm, angeordnet sind. Der ebene Aufbau der Elektroden bzw. der zugehörigen Elektroadhäsionsfläche (Greiffläche) ermöglicht einen Zugriff auf Werkstücke mit ebenen Außenflächen, was sehr häufig anzutreffen ist. Der geringe oder verschwindende Abstand gestattet die Einrichtung von hohen Feldstärken und damit hohen Adhäsionskräften.

Bei einer alternativen, vorteilhaften Ausführungsform ist vorgesehen, dass die beiden spiralförmigen Elektroden an einer im Wesentlichen konusmantelförmigen oder glockenförmigen Innenseite eines gemeinsamen Trägers angeordnet oder ausgebildet sind und helixartig verlaufen. Der Träger mit der konusmantelförmigen oder glockenförmigen Innenseite kann insbesondere ein flexibler Saugkörper einer Sauggreifer-Zusatzfunktion sein. Die Elektroadhäsion unterstützt dann einen sicheren Halt des Sauggreifers im angesaugten Zustand.

Eine vorteilhafte Ausführungsform sieht vor, dass die beiden spiralförmigen Elektroden und das Dioden-Bauteil auf einer selbstklebenden Folie angeordnet sind, die auf einer werkstückzugewandte Seite des Elektroadhäsionsgreifers aufgeklebt ist. Dies ist für die Fertigung der Elektroden und deren Anbringung am Greifer besonders einfach. Man beachte, dass die selbstklebende Folie auch mehrschichtig aufgebaut sein kann. Eine selbstklebende Folie ist auch an bestehenden Greifern (etwa Sauggreifern oder Magnetgreifern) leicht nachzurüsten.

Ebenfalls vorteilhaft ist eine Ausführungsform, bei der die beiden Elektroden auf einer werkstückzugewandten Seite von einer Isolierschicht bedeckt sind. Dies verhindert einen Kurzschluss der Elektroden über ein ergriffenes, leitfähiges (etwa metallisches) Werkstück, so dass auch ein solches Werkstück ohne besondere Präparation ergriffen werden kann.

Bei einer Weiterbildung dieser Ausführungsform ist vorgesehen, dass auf einer werkstückzugewandten Seite der Isolierschicht eine Verschleißschicht angeordnet ist, insbesondere wobei die Verschleißschicht aus einem graphithaltigen Kunststoff oder einem mit Metallpartikeln angereicherten Kunststoff besteht. Die Verschleißschicht verhindert zum einen eine Abnutzung der Elektroden oder der sie schützenden Isolierschicht; zum anderen erleichtert sie die Zustandsüberwachung des Elektroadhäsionsgreifers. Bevorzugt wird ein von der Dicke der Verschleißschicht kontinuierlich abhängiger Parameter gelegentlich bestimmt, um den Verschleißgrad des Greifers zu ermitteln.

Besonders bevorzugt ist eine Ausführungsform des erfindungsgemäßen Elektroadhäsionsgreifers, die vorsieht, dass am Elektroadhäsionsgreifer zusätzlich ein Sauggreifer ausgebildet ist, wobei der Sauggreifer einen von einem Saugkörper und einer Dichtlippe begrenzten Saugraum ausbildet, insbesondere wobei eine Greiffläche des Elektroadhäsionsgreifers und eine Greiffläche des Sauggreifers zumindest teilweise überlappen oder aneinander grenzen. Die Elektroadhäsionsfunktion und die Sauggreiferfunktion können sich gegenseitig ergänzen und verstärken. Werkstücke, die mit zahlreichen Durchbrüchen oder Einschnitten versehen sind (und daher mit einen Sauggreifer wegen zu großer Leckrate nicht handhabbar sind), können über die Elektroadhäsionsfunktion manipuliert werden. Die Greifflächen bezeichnen diejenigen Flächen der jeweiligen Halteunktion, in denen eine Haltekraft aufgebracht wird. Durch geeignete Aufteilung der Greifflächen kann eine Anpassung an einen bestimmten Werkstücktypus erfolgen, insbesondere wobei durchbruchbehaftete Flächen der Elektroadhäsionsfunktion zugeordnet sind.

Besonders bevorzugt ist eine Weiterbildung dieser Ausführungsform, bei der zumindest jeweils ein Teil der beiden spiralförmigen Elektroden in einem werkstückzugewandten Bereich der Dichtlippe oder unmittelbar angrenzend an den werkstückzugewandten Bereich der Dichtlippe ausgebildet ist. Dadurch kann die Elektroadhäsionsfunktion die Abdichtung des Sauggreifers gegen das Werkstück im Bereich der Dichtlippe unterstützen, so dass eine Leckrate des Sauggreifers verringert werden kann.

Eine andere, vorteilhafte Weiterbildung sieht vor, dass jeweils zumindest ein Teil der beiden spiralförmigen Elektroden, und bevorzugt auch das Dioden-Bauteil, im Bereich einer werkstückzugewandten Seite des Saugkörpers in den Saugkörper integriert sind. Dadurch kann eine verlängerte Standzeit und Dauerlaufgüte erreicht werden; die Leiterbahnen der Elektroden erhalten durch die Einbettung (typischerweise Kunststoffeinbettung in den aus einem Elastomer aufgebauten Saugerbereich) einen leistungsfähigen mechanischen Schutz.

Ebenfalls besonders bevorzugt ist eine Ausführungsform, bei der am Elektroadhäsionsgreifer zusätzlich ein Magnetgreifer ausgebildet ist, insbesondere wobei eine Greiffläche des Elektroadhäsionsgreifers und eine Greiffläche des Magnetgreifers zumindest teilweise überlappen oder aneinander grenzen. Die Elektroadhäsionsfunktion und die Magnetgreiferfunktion können sich gegenseitig ergänzen und verstärken. Werkstücke, die zumindest teilweise unmagnetisch sind (und daher mit einen Magnetgreifer nicht handhabbar sind), können über die Elektroadhäsionsfunktion manipuliert werden. Die Greifflächen bezeichnen diejenigen Flächen der jeweiligen Halteunktion, in denen eine Haltekraft aufgebracht wird. Durch geeignete Aufteilung der Greifflächen kann eine Anpassung an einen bestimmten Werkstücktypus erfolgen, insbesondere wobei unmagnetische Flächen der Elektroadhäsionsfunktion zugeordnet sind. Man beachte, dass durch das elektrische Feld der Elektroadhäsionsfunktion das magnetische Feld der Magnetgreiferfunktion in keiner Weise beeinträchtigt wird und umgekehrt.

Eine vorteilhafte Weiterbildung dieser Ausführungsform sieht vor, dass zumindest ein Teil einer Greiffläche des Elektroadhäsionsgreifers ringförmig um eine Greiffläche des Magnetgreifers angeordnet ist. Ein ringförmiger Bereich um den Magnetgreifer ist leicht mit umlaufenden spiralförmigen Elektroden für eine Elektroadhäsionsfunktion auszustatten.

Bevorzugt ist es dabei, wenn der Teil der Greiffläche des Elektroadhäsionsgreifers, der die Greiffläche des Magnetgreifers ringförmig umschließt, gefedert gelagert ist, insbesondere wobei dieser Teil in eine Position vorgespannt ist, in der dieser Teil gegenüber der Greiffläche des Magnetgreifers hervorsteht, und insbesondere wobei dieser Teil in einzeln bewegliche, gefedert gelagerte Sektoren unterteilt ist. Die federnde Lagerung ermöglicht eine Anpassung an eine unebene Gestalt eines Werkstücks für eine bessere Greiffunktion des Hybridgreifers; man beachte, dass die Federung bevorzugt auch eine gewisses Spiel bezüglich einer Verkippung einräumt. Durch eine sektorielle Aufteilung kann eine noch feinere Anpassung an die Gestalt des Werkstücks erfolgen.

In den Rahmen der vorliegenden Erfindung fällt auch ein Verfahren zum Betrieb eines erfindungsgemäßen, oben beschriebenen Elektroadhäsionsgreifers, das dadurch gekennzeichnet ist, dass zwischen den beiden Elektroden eine Wechselspannung angelegt wird. Die Wechselspannung, die insbesondere zum Ergreifen und Halten eines Werkstücks (das dielektrisch oder auch metallisch sein kann) eingesetzt wird, gestattet sowohl eine gute Greiffunktion als auch eine einfache Belegungsüberprüfung beim erfindungsgemäßen Elektroadhäsionsgreifer. Das Ergreifen und/oder Halten kann durch eine Saugfunktion und/oder eine Magnethaltefunktion unterstützt werden, sofern der Elektroadhäsionsgreifer dafür eingerichtet ist. Die Wechselspannung wechselt zeitlich regelmäßig zwischen einem aufgeladenen und entladenen Zustand der Elektroden. Die Wechselspannung hat bevorzugt einen zumindest näherungsweise sinusförmigen Verlauf. Man beachte, dass die Wechselspannung von Halbwelle zu Halbwelle nicht notwendigerweise die Polarität wechseln muss.

In einer bevorzugten Variante des erfindungsgemäßen Verfahrens ist vorgesehen, dass die Wechselspannung eine Amplitude in einem Bereich zwischen 1 kV und 20 kV, bevorzugt zwischen 5 kV und 10 kV, aufweist, und/oder dass die Wechselspannung eine Frequenz in einem Bereich zwischen 500 Hz und 20 kHz, bevorzugt zwischen 1 kHz und 10 kHz, aufweist. Mit diesen Amplituden (Spitze zu null) und Frequenzen wurden in der Praxis gute Resultate erzielt. Man beachte, dass im Allgemeinen zum Ergreifen von leitfähigen Werkstücken eine Wechselspannung mit höherer Frequenz (meist 1 kHz oder größer, bevorzugt 2 kHz oder größer) eingesetzt wird.

Bei einer besonders vorteilhaften Verfahrensvariante weisen mehrere aufeinanderfolgende Halbwellen der Wechselspannung eine gleiche, erste Polarität auf, wobei das Dioden-Bauteil bei dieser ersten Polarität sperrt. In der ersten Polarität kann die Adhäsionsfunktion voll genutzt werden; zwischen den (elektrisch voneinander effektiv isolierten) Elektroden kann sich das elektrische Feld aufbauen. Typischerweise weist die ganz überwiegende Mehrzahl (90% oder mehr, bevorzugt 99% oder mehr) der Halbwellen die erste Polarität auf. Über die mehreren, aufeinanderfolgenden Halbwellen der ersten Polarität bleibt die Adhäsionskraft im Wesentlichen erhalten; das Werkstück wird besonders sicher und fest gehalten.

Vorteilhaft ist eine Verfahrensvariante, bei der während einer oder mehrerer aufeinanderfolgender Halbwellen der Wechselspannung mit einer zweiten Polarität, bei der das Dioden-Bauteil leitet, eine Bestimmung der Belegung des Elektroadhäsionsgreifers erfolgt. Zur Belegungsprüfung wird eine von der Induktivität der in Serie geschalteten Teile der beiden spiralförmigen Elektroden abhängige Messgröße bestimmt; durch Belegung oder Nichtbelegung ändert sich die magnetische Suszeptibilität in der näheren Umgebung der Elektroden erheblich (oft um einen Faktor bis 10³), was sich auf die effektive Induktivität auswirkt. Bevorzugt wird das Aufladeverhalten der nun als Messspule wirkenden, in Serie geschalteten Teile der Elektroden vermessen, etwa über einen zeitlichen Verlauf der Spannung an den Elektroden bei deren Aufladung typischerweise über einen Vorwiderstand bei bekanntem zeitlichen Verlauf der Ladespannung (hierbei wird typischerweise bestimmt, nach welcher Zeit eine bestimmte Spannung an den Elektroden erreicht ist, oder welche Spannung an den Elektroden nach einer bestimmten Zeit erreicht ist). Solche Messungen brauchen grundsätzlich nur über eine einzige Halbwelle (oder gar nur eine halbe Halbwelle) zu erfolgen; bevorzugt wird daher bei einer Belegungsmessung spätestens nach einer Halbwelle der zweiten Polarität wieder in die erste Polarität des Adhäsionsbetriebs gewechselt, um ein gehaltenes Werkstück nicht zu verlieren bzw. schnell wieder mit hoher Kraft zu halten. Typischerweise weisen nur sehr wenige Halbwellen (typischerweise 10% oder weniger, bevorzugt 1% oder weniger) die zweite Polarität auf. Man beachte, dass gemäß dieser Variante Halbwellen der zweiten Polarität auch ohne eine Belegungsmessung ablaufen können (insbesondere wenn unabhängig von einer Veranlassung durch eine Belegungsmessung zwischen erster und zweiter Polarität periodisch umgeschaltet wird). Ebenso ist es möglich, zur Belegungsprüfung die Elektroden mit einer Halbwelle oder einigen aufeinanderfolgenden Halbwellen der zweiten Polarität zu beaufschlagen, nachdem zuvor die Wechselspannung abgeschaltet wurde, um ein Werkstück abzulegen.

Bevorzugt ist auch eine Verfahrensvariante, bei der während einer oder mehrerer aufeinanderfolgender Halbwellen der Wechselspannung mit einer zweiten Polarität, bei der das Dioden-Bauteil leitet, eine Bestimmung des Verschleißgrads des Elektrodhäsionsgreifers erfolgt. Für die Bestimmung des Verschleißgrads (etwa der Bestimmung der verbleibenden Dicke einer werkstückseitig an den Elektroden angebrachten Verschleißschicht) wird in der Regel die Induktivität der Gesamtheit der von dem Dioden-Bauteil in Serie verbundenen Teile der Elektroden genau bestimmt, etwa über die Resonanzfrequenz oder Güte eines Schwingkreises, der die besagte Gesamtheit enthält. Die Induktivität wird über den Suszeptibilitätsbeitrag der Verschleißschicht beeinflusst. Eine Verschleißgradmessung erfolgt typischerweise über eine größere Zahl von Halbwellen der zweiten Polarität (beispielsweise zehn oder mehr). Bevorzugt ist während einer solchen Messung kein Werkstück gehalten, um die Suszeptibilitätsänderung der veränderlich dicken Verschleißschicht nicht durch den meist sehr großen Suszeptibilitätsbeitrag des Werkstücks zu überlagen. Weiterhin wird auch die Gefahr verringert, das Werkstück über die Dauer der Messung zu verlieren.

Bei einer vorteilhaften Variante ist weiterhin vorgesehen, dass zum Ablegen eines Werkstücks die Wechselspannung zwischen den Elektroden abgeschaltet wird und das Werkstück vom Elektroadhäsionsgreifer abgeblasen wird. Dadurch ist ein besonders schnelles Ablegen möglich, insbesondere auch dann, wenn noch eine gewisse Elektroadhäsion wegen einer (kapazitiv gehaltenen) Restspannung wirkt. Diese Variante kann besonders gut bei einem Elektroadhäsionsgreifer mit zusätzlicher Sauggreiferfunktion eingesetzt werden; bei Vakuumsaugern ist ein Abblasen im Betriebszyklus ohnehin vorhanden.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1a: eine schematische Aufsicht auf die Elektrodenanordnung einer ersten Ausführungsform eines erfindungsgemäßen Elektroadhäsionsgreifers, mit einer an den inneren Elektrodenenden angeschlossenen Diode;
- Fig. 1b: einen schematischen Querschnitt durch die Elektrodenanordnung von Fig. 1a bei Ebene Ib, bei einschichtigem Aufbau;
- Fig. 1c: einen schematischen Querschnitt durch die Elektrodenanordnung von Fig. 1 a bei Ebene Ib, bei zweischichtigem Aufbau;
- Fig. 2: eine schematische Aufsicht auf die Elektrodenanordnung einer zweiten Ausführungsform eines erfindungsgemäßen Elektroadhäsionsgreifers, mit einer zwischen der zweitäußersten Windung einer ersten Elektrode und der äußersten Windung einer zweiten Elektrode angeschlossenen Diode;
- Fig. 3a: eine schematische Aufsicht auf die Elektrodenanordnung einer dritten Ausführungsform eines erfindungsgemäßen Elektroadhäsionsgreifers, mit einer zwischen der äußersten Windung einer ersten Elektrode und dem inneren Ende einer zweiten Elektrode angeschlossenen Diode;
- Fig. 3b: einen schematischen Querschnitt durch den Elektroadhäsionsgreifer von Fig. 3a bei Ebene IIIb;
- Fig. 4: eine schematische Aufsicht auf die Elektrodenanordnung einer vierten Ausführungsform eines erfindungsgemäßen Elektroadhäsionsgreifers, mit einer an den inneren Elektrodenenden angeschlossenen Diode, wobei die erste Elektrode zusätzliche, radial innen liegende Windungen aufweist;
- Fig. 5: eine schematische Aufsicht auf die Elektrodenanordnung einer fünften Ausführungsform eines erfindungsgemäßen Elektroadhäsionsgreifers, mit einer an den inneren Elektrodenenden angeschlossenen Diode, wobei die erste Elektrode zusätzliche, radial außen liegende Windungen aufweist;
- Fig. 6: eine schematische Aufsicht auf die Elektrodenanordnung einer sechsten Ausführungsform eines erfindungsgemäßen Elektroadhäsionsgreifers, mit einem außen verringerten radialen Abstand der Elektroden;
- Fig. 7: eine schematische Aufsicht auf die Elektrodenanordnung einer siebten Ausführungsform eines erfindungsgemäßen Elektroadhäsionsgreifers, mit über Eck verlaufenden Elektroden und einem Dioden-Bauteil umfassend drei in Serie geschaltete Dioden;
- Fig. 8: eine schematische Darstellung des zeitlichen Verlaufs einer an die Elektroden eines erfindungsgemäßen Elektrodenadhäsionsgreifers angelegten Wechselspannung;
- Fig. 9: einen schematischen Querschnitt durch einen erfindungsgemäßen Elektroadhäsionsgreifer ohne zusätzliche Greiffunktionen;
- Fig. 10: einen schematischen Querschnitt durch einen erfindungsgemäßen Elektroadhäsionsgreifer, mit zusätzlicher Sauggreiferfunktion, mit ebener Elektroadhäsionsfläche;
- Fig. 11: einen schematischen Querschnitt durch einen erfindungsgemäßen Elektroadhäsionsgreifer, mit zusätzlicher Sauggreiferfunktion, mit konusmantelförmiger Elektroadhäsionsfläche;
- Fig. 12a: einen schematischen Querschnitt durch einen erfindungsgemäßen Elektroadhäsionsgreifer, mit zusätzlicher Magnetgreiferfunktion, in einem Grundzustand;
- Fig. 12b: den Elektroadhäsionsgreifer von Fig. 12a, mit ergriffenem Werkstück;
- Fig. 12c: eine schematische unterseitige Ansicht des Elektroadhäsiongsgreifers von Fig. 12a.

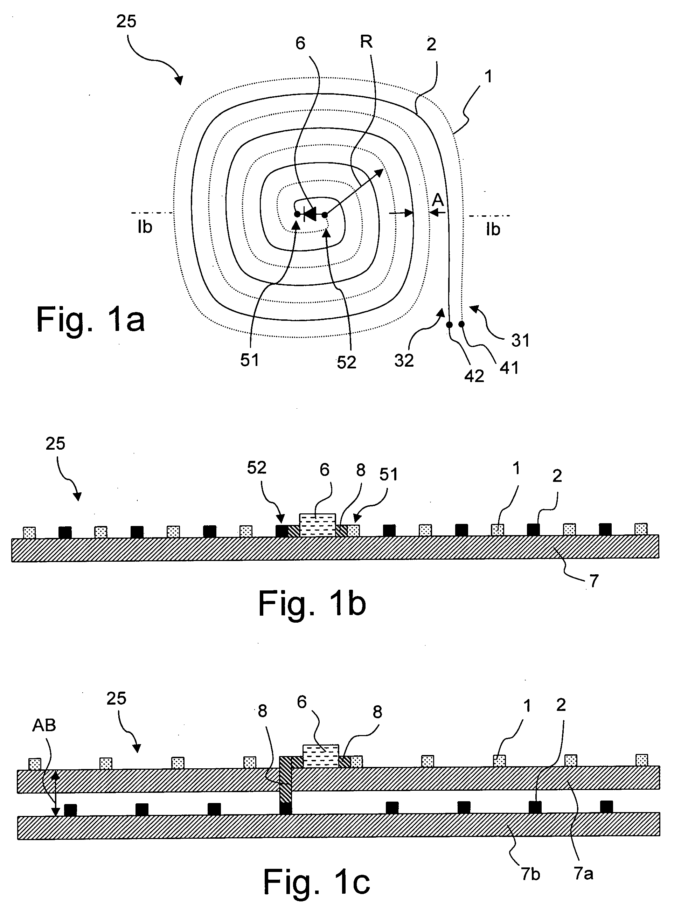

Die **Fig. 1a** zeigt in einer schematischen Aufsicht den Bereich einer Elektrodenanordnung 25 einer ersten Ausführungsform eines erfindungsgemäßen Elektroadhäsionsgreifers.

Die Elektrodenanordnung 25 umfasst eine erste, spiralförmige Elektrode 1 (gepunktet dargestellt) und eine zweite, spiralförmige Elektrode 2 (durchgezogen dargestellt). Die beiden Elektroden 1, 2 verlaufen vollständig bifilar und umfassen je ca. vier Windungen; der Abstand A der Elektroden 1, 2 (gemessen näherungsweise senkrecht zum lokalen Elektrodenverlauf) ist hier im Wesentlichen bei allen Spiralradien R gleich. An jeweils einem äußeren Ende 31, 32 der Elektroden 1, 2 sind Spannungsanschlüsse 41, 42 zum Anschließen einer elektrischen Spannung (bevorzugt einer Wechselspannung) vorgesehen. An den inneren Enden 51, 52 der Elektroden 1, 2 ist ein Dioden-Bauteil 6, hier umfassend eine einzelne Diode, angeschlossen; die inneren Enden 51, 52 können hier auch als die entfernt von den Spannungsanschlüssen 41, 42 liegenden Enden bezeichnet werden.

Für den Elektroadhäsionsbetrieb wird die Spannung mit einer Polarität in Sperrrichtung des Dioden-Bauteils 6 (d.h. mit einem höheren elektrischen Potential am Spannungsanschluss 42 als am Spannungsanschluss 41) angeschlossen. Zwischen den dann voneinander isolierten Elektroden 1, 2 bildet sich ein elektrisches Feld aus, welches ein flächig anliegendes Werkstück (etwa oberhalb der Zeichenebene, nicht dargestellt), anzieht.

Für eine Belegungsmessung wird die Spannung mit einer Polarität in Durchlassrichtung (d.h. mit einem höheren elektrischen Potential am Spannungsanschluss 41 als am Spannungsanschluss 42) angeschlossen. Die beiden spiralförmigen Elektroden 1, 2 sind dann in Serie verschaltet. Dabei heben sich die Induktivitäten der beiden Elektroden 1, 2 weitgehend auf, da die beiden Elektroden 1, 2 in entgegengesetzter Richtung vom elektrischen Strom durchflossen werden. Da die weiter außen beginnende erste spiralförmige Elektrode 1 eine etwas größere Fläche einnimmt und auch zum inneren Ende hin etwas länger (bezogen auf die Windungszahl) ist als die zweite Elektrode 2, verbleibt eine nicht verschwindende Induktivität der über das Dioden-Bauteil 6 in Serie verbundenen Elektroden 1, 2. Diese Induktivität wird durch ein gegebenenfalls in der Nähe der Elektrodenanordnung 25 vorhandenes Werkstück beeinflusst, was durch eine geeignete Messung (etwa den zeitlichen Verlauf des Spannungsaufbaus über eine Halbwelle der Wechselspannung) festgestellt werden kann.

**Fig. 1b** zeigt einen schematischen Schnitt durch die Elektrodenanordnung 25 von Fig. 1a bei Ebene Ib. Auf einem Träger 7, der hier als eine selbstklebenden Folie (mit der klebenden Seite nach oben) ausgebildet ist, sind die Leiterbahnen der ersten Elektrode 1 (gepunktet dargestellt) und der zweiten Elektrode 2 (ausgefüllt dargestellt) angeordnet, und das Dioden-Bauteil 6 verbindet die inneren Enden 51, 52 der Elektroden 1, 2 über Leiterverbindungen 8. Mit anderen Worten, die Ebenen, in denen die Elektroden 1, 2 angeordnet sind, fallen zusammen. Dieser einschichtige Aufbau ist gut möglich, da die Elektrodenanordnung 25 keinerlei Kreuzungen von Leiterbahnen aufweist.

Alternativ kann auch ein zweischichtiger Aufbau vorgesehen sein, bei dem die Elektroden 1, 2 auf unterschiedlichen Trägern 7a, 7b angeordnet sind, vgl. **Fig. 1c**, wobei hier die erste Elektrode 1 und das Dioden-Bauteil 6 auf dem oberen Träger 7a angeordnet sind. In diesem Fall ist eine Durchkontaktierung 8a notwendig, um das Dioden-Bauteil 6 mit der zweiten Elektrode 2 auf dem unteren Träger 7b leitend zu verbinden. Die beiden Träger 7a, 7b sind bevorzugt miteinander verklebt. Der Abstand AB der parallelen Ebenen, in denen die beiden Elektroden 1, 2 jeweils angeordnet sind (bzw. der Abstand AB der Oberseiten der Träger 7a, 7b, auf denen die Elektroden 1, 2 aufgebracht sind) beträgt bevorzugt 3 mm oder weniger, besonders bevorzugt 2 mm oder weniger; bei Verwendung von folienartigen Trägern 7a, 7b kann der Abstand AB auch leicht 500 µm oder weniger betragen.

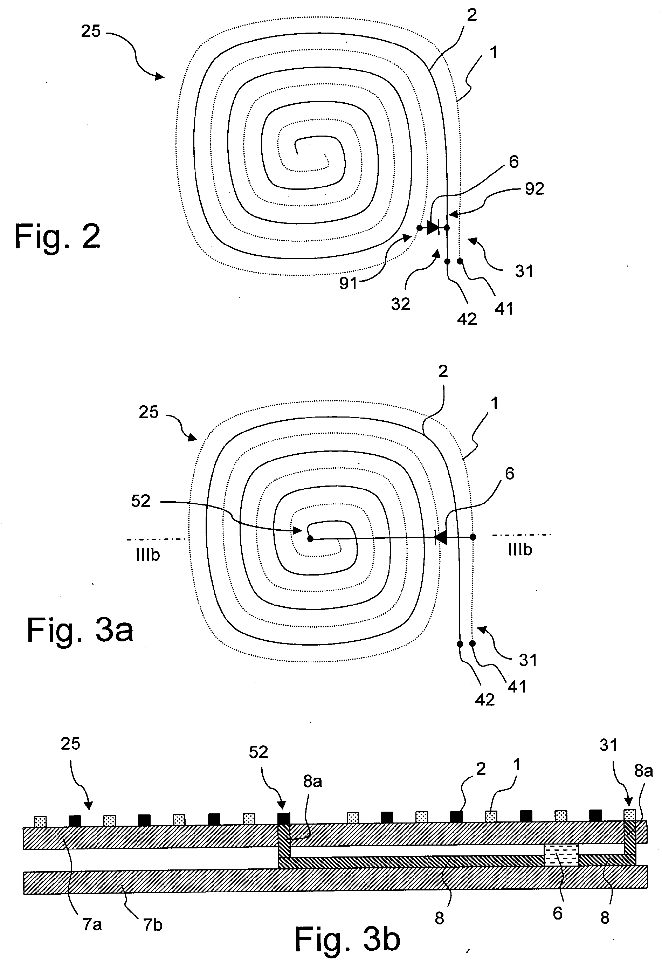

**Fig. 2** zeigt in einer zweite Ausführungsform eine Elektrodenanordnung 25 für die Erfindung. Hierbei ist die (von außen gezählt) erste Windung der zweiten Elektrode 2 mit der (von außen gezählt) zweiten Windung der ersten Elektrode 1 über das Dioden-Bauteil 6 verbunden; das Dioden-Bauteil 6 verbindet dabei direkt benachbarte Teilabschnitte 91, 92 der Elektroden 1, 2. Die (äußeren) Enden 31, 32, an denen die Spannungsanschlüsse 41, 42 eingerichtet sind, sind hier im Wesentlichen bei der gleichen Drehwinkelposition der beiden spiralförmigen Elektroden 1, 2 ausgebildet.

Bei Anlegen einer Spannung an die Spannungsanschlüsse 41, 42 in Durchlasspolarität kann ein Strom vom Spannungsanschluss 41 über einen Teil der ersten Elektrode 1, nämlich die äußerste Windung der ersten Elektrode 1, bis zum Dioden-Bauteil 6, dann durch das Dioden-Bauteil 6 und schließlich über einen sehr kurzen Teil der zweiten Elektrode 2 zum Spannungsanschluss 42 fließen. Dadurch wird eine (verglichen mit der Elektrodenanordnung von Fig. 1a) relativ hohe Induktivität der über das Dioden-Bauteil 6 in Serie verbunden Teile der Elektroden 1, 2 bereitgestellt, da die Fläche der äußersten Windung der ersten Elektrode 1 recht groß ist.

Eine noch größere Induktivität der in Durchlasspolarität über das Dioden-Bauteil 6 verbunden Teile der ersten und zweiten Elektrode 1, 2 kann die in **Fig. 3a** gezeigte Ausführungsform bereitstellen. Das Dioden-Bauteil 6 verbindet hier die äußerste Windung der ersten Elektrode 1 nahe am äußeren Ende 31 (an welchem der Spannungsanschluss 41 ausgebildet ist) mit dem inneren Ende 52 der zweiten Elektrode 2. Ein Strom kann hier vom Spannungsanschluss 41 über einen kleinen Teil der ersten Elektrode 1 durch das Dioden-Bauteil 6 und sodann durch die gesamte, zweite Elektrode 2 bis zum Spannungsanschluss 42 fließen. Es werden somit alle ca. vier Windungen der zweiten Spule 2 genutzt.

Allerdings erfordert diese Ausführungsform einen zweischichtigen Aufbau, vgl. den in **Fig. 3b** dargestellten schematischen Schnitt bei Ebene IIIb in Fig. 3a. Die Verbindung zwischen der zweiten Elektrode 2 am inneren Ende 52 und der ersten Elektrode 1 am äußeren Ende 31 erfordert ein Kreuzen der radial dazwischen liegenden Windungen. Daher werden in der gezeigten Ausführungsform die Elektroden 1, 2 auf einem ersten (hier oberen) Träger 7a angeordnet, und die Leiterverbindungen 8 zwischen den beiden Durchkontaktierungen 8a und dem Dioden-Bauteil 6 sind, ebenso wie das Dioden-Bauteil 6 selbst, auf einem zweiten (hier unteren) Träger 7b angeordnet. Die beiden Träger 7a, 7b sind wiederum bevorzugt miteinander verklebt.

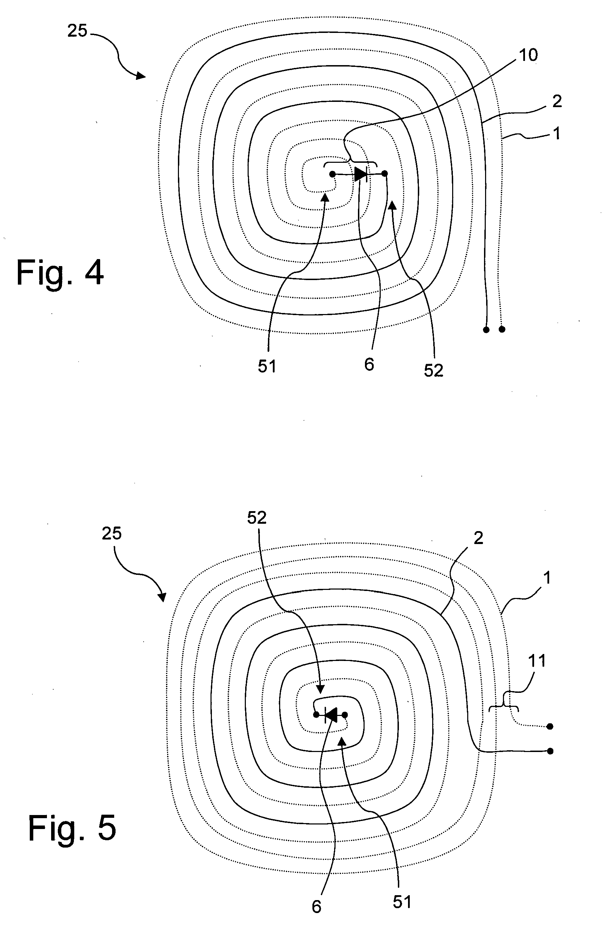

In **Fig. 4** ist die Elektrodenanordnung 25 einer Ausführungsform eines Elektroadhäsionsgreifers dargestellt, bei der über das Dioden-Bauteil 6 die inneren Enden 51, 52 der Elektroden 1, 2 verbunden sind. Allerdings weist hier die erste Elektrode 1 gegenüber der zweiten Elektrode 2 im radial inneren Bereich drei zusätzliche Windungen 10 auf. Diese vergrößern die Induktivität der ersten Elektrode 1 gegenüber der zweiten Elektrode 2, so dass die Induktivität der durch das Dioden-Bauteil 6 in Durchlasspolarität in Serie geschalteten (hier vollständigen) Elektroden 1, 2 gegenüber der Ausführungsform von Fig. 1 a deutlich vergrößert ist. Man beachte, dass die zusätzlichen Windungen 10 der ersten Elektrode mangels Pendant in der zweiten Elektrode 2 nicht bifilar angeordnet sind.

In ähnlicher Weise ist es möglich, zusätzliche Windungen 11 der ersten Elektrode 1 radial außen vorzusehen, vgl. **Fig. 5**. In der Serienschaltung der (hier vollständigen) Elektroden 1, 2 über das Dioden-Bauteil 6 an den inneren Enden 51, 52 vergrößern diese (hier zwei) zusätzlichen Windungen 11 wiederum die Induktivität der ersten Spule 1 gegenüber der zweiten Spule 2. Die zusätzlichen Windungen 11 sind wiederum mangels Entsprechung in der zweiten Elektrode 2 nicht bifilar angeordnet.

Man beachte, dass in den Ausführungsformen von Fig. 4 und Fig. 5 Leiterkreuzungen eingerichtet werden müssen.

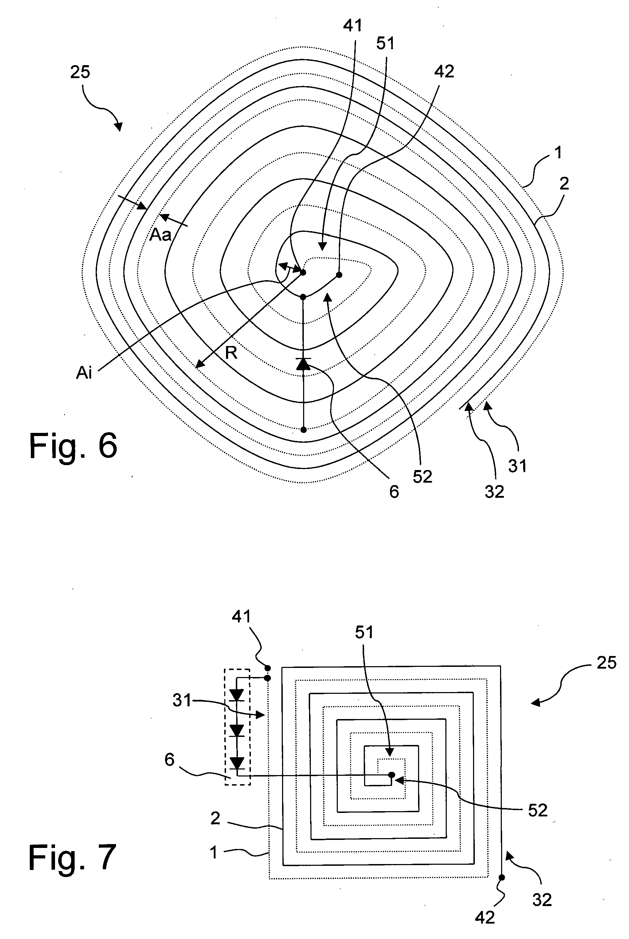

**Fig. 6** zeigt eine Ausführungsform, bei der der Abstand der Elektroden 1, 2 (gemessen näherungsweise senkrecht zum lokalen Elektrodenverlauf) bei kleinem Spiralradius R, also in einem radial inneren Bereich (vgl. Abstand Ai) größer ist als bei großem Spiralradius R, also in einem radial äußeren Bereich (vgl. Abstand Aa, jeweils bei näherungsweise gleicher Drehwinkelposition). Durch den radial außen geringeren Elektrodenabstand Aa wird dort eine größere elektrische Feldstärke zwischen den Elektroden 1, 2 bei Anlegen einer Spannung an die Spannungsanschlüsse 41, 42 in Sperrpolarität erreicht. Man beachte, dass hier die Spannungsanschlüsse 41, 42 an den inneren Enden 51, 52 der Elektroden 1, 2 eingerichtet sind. Die äußeren Enden 31, 32 sind frei; die äußeren Enden 31, 32 können hier als die von den Spannungsanschlüssen 41, 42 entfernten Enden der Elektroden 1, 2 bezeichnet werden.

In Durchlasspolarität kann bei dieser Ausführungsform ein Strom vom Spannungsanschluss 41 durch einen inneren Teil (nämlich die innersten zweieinhalb Windungen) der ersten Elektrode 1, weiter durch das Dioden-Bauteil 6 und schließlich durch einen kurzen Teil der zweiten Elektrode 2 bis zum Spannungsanschluss 42 fließen.

Die **Fig. 7** zeigt eine Ausführungsform, bei der die Elektroden 1, 2 jeweils aus gerade verlaufenden Abschnitten bestehen, die an rechtwinkligen Ecken aneinander stoßen.

Die Spannungsanschlüsse 41, 42 sind an den äußeren Enden 31, 32 der Elektroden 1, 2 ausgebildet, wobei die äußeren Enden 31, 32 bei um 180° versetzten Drehwinkeln der spiralförmigen Elektroden 1, 2 ausgebildet sind. Das innere Ende 52 der zweiten Elektrode 2 ist hier über ein Dioden-Bauteil 6 mit der ersten Elektrode 1 im Bereich deren äußeren Endes 31 verbunden, so dass die Induktivität der über das Dioden-Bauteil 6 in Serie verbunden Teile der Elektroden 1, 2 im Wesentlichen der Induktivität der zweiten Elektrode 2 entspricht.

Als weitere Besonderheit weist das Dioden-Bauteil 6 (hier) drei in Serie geschaltete Dioden auf. Dadurch kann in Sperrpolarität eine entsprechend ca. dreifach höhere Spannung als bei Verwendung von nur einer Diode angelegt werden, ohne dass es zu einem Spannungsdurchbruch am Dioden-Bauteil 6 kommt.

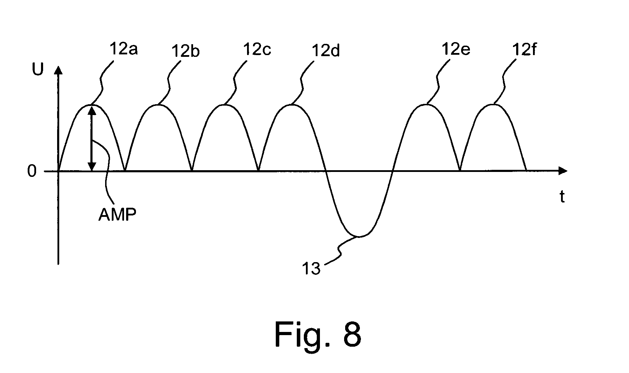

**Fig. 8** illustriert beispielhaft den zeitlichen Verlauf einer Wechselspannung, vgl. Spannung U als Funktion der Zeit t im Diagramm von Fig. 8, mit der ein Elektroadhäsionsgreifer gemäß der Erfindung betrieben werden kann. Die Spannung U kann direkt oder über einen Vorwiderstand an die Spannungsanschlüsse der Elektrodenanordnung eines erfindungsgemäßen Elektroadhäsionsgreifers angelegt werden.

Die Spannung U hat einen grundsätzlich sinusförmigen Verlauf mit einer Vielzahl von Halbwellen, hier mit einer konstanten Amplitude AMP. Allerdings weist die überwiegende Zahl der Halbwellen (hier beispielhaft eingezeichnet die ersten vier aufeinander folgenden Halbwellen 12a-12d und auch die letzten beiden eingezeichneten, aufeinanderfolgenden Halbwellen 12e-12f) eine gleiche, erste Polarität auf, und eine Minderheit von Halbwellen (hier beispielhaft eingezeichnet die Halbwelle 13) weist eine zweite Polarität auf.

Die erste Polarität entspricht der Sperrrichtung des Dioden-Bauteils des Elektroadhäsionsgreifers, in der zwischen den Elektroden ein starkes elektrisches Feld aufgebaut wird, und mit der Werkstücke (etwa Bleche) ergriffen und gehalten werden können. Man beachte, dass für die Greiffunktion die Spannungsquelle eine Leistung von typischerweise lediglich 1-5 Watt für nichtmetallische Werkstücke und typischerweise 10-50 Watt für metallische Werkstücke bereitstellen muss.

Die zweite Polarität entspricht der Durchlassrichtung des Dioden-Bauteils, mit der die durch das Dioden-Bauteil in Serie geschalteten Teile der Elektroden eine Messspule einrichten und eine Belegungsprüfung (also die Prüfung, ob gerade ein Werkstück am Elektroadhäsionsgreifer gehalten wird oder nicht) erfolgen kann. Je nach Belegung ist die Induktivität der Messspule verschieden, was durch geeignete Messungen festgestellt werden kann. Belegungsmessungen können zur Prüfung eingesetzt werden, ob ein Werkstück erfolgreich ergriffen wurde, und/oder ob ein Werkstück zwischenzeitlich (während einer Haltezeit, in der das Werkstück typischerweise transportiert wird) verloren wurde, und/oder ob ein Werkstück erfolgreich abgelegt wurde.

Für eine Belegungsmessung braucht in der Regel keine genaue Bestimmung der Induktivität der Messspule zu erfolgen; eine grobe Auswertung des Aufladeverhaltens (etwa über eine halbe Halbwelle) genügt meist.

Wird eine genauere Bestimmung der Induktivität vorgenommen, etwa über die Bestimmung der Resonanzfrequenz oder Güte eines die Messspule enthaltenden Schwingkreises (wofür typischerweise zehn oder mehr aufeinanderfolgende Halbwellen der zweiten Polarität vermessen werden, nicht eingezeichnet), kann auch der Verschleißgrad des Elektroadhäsionsgreifers bzw. die verbleibende Dicke einer Verschleißschicht auf dem Elektroadhäsionsgreifer bestimmt werden. Diese Messung erfolgt bevorzugt ohne Werkstück; alternativ kann die Messung auch mit Werkstück erfolgen, wobei dann aber die Suzeptibilitätseigenschaften des Werkstücks (bzw. dessen Einfluss auf die Induktivität in Abhängigkeit von der Dicke der Verschleißschicht) bekannt sein sollten, und die Messung so kurz sein sollte, dass das Werkstück noch nicht vom Greifer fällt.

Ergänzend können auch allgemeine Prüfungen vorgenommen werden, etwa bezüglich des Zustands des Elektroadhäsionsgreifers (gut/defekt; bei zusätzlicher Saugfunktion auch Sauger gut/kaputt), der Bauart des Elektroadhäsionsgreifers (Eignung für bestimmte Transportaufgaben, Eignung zur Handhabung von bestimmten Werkstücken, ggf. abhängig von der Orientierung eines Greiferrahmens, Größe der Greifflächen, Lebensdauer) und ähnliches.

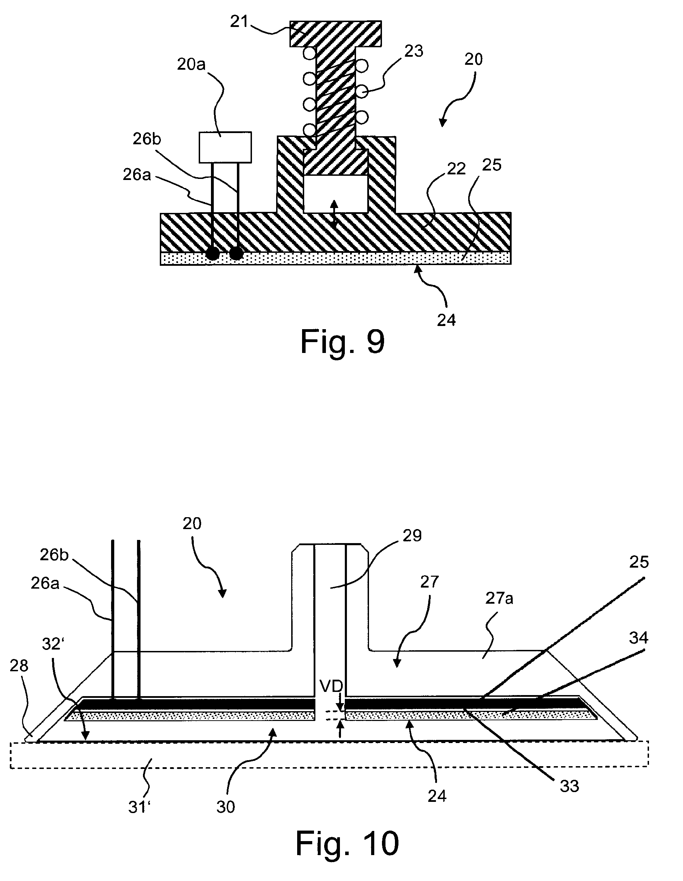

Die **Fig. 9** zeigt einen erfindungsgemäßen Elektroadhäsionsgreifer 20, mit einer Greiferbasis 21 (die beispielsweise an einem Roboterarm befestigt ist) und einem an der Greiferbasis 21 gelagerten Greiferkopf 22. An der Unterseite des Greiferkopfs 22 ist eine (hier flache) Elektrodenanordnung 25 angebracht, die eine (hier ebene) Greiffläche (Elektroadhäsionsfläche) 24 ausbildet. Die Elektrodenanordnung 25 wird über zwei Kabellitzen 26a, 26b, die zu den Spannungsanschlüssen der Elektroden führen, mit Betriebsspannung aus einer Steuereinrichtung 20a versorgt und mittels der Steuereinrichtung 20a für Belegungsprüfungen vermessen.

Der Greiferkopf 22 ist gegen die Kraft einer Feder 23 relativ zur Greiferbasis 21 verfahrbar, so dass bei Aufsetzen des Elektroadhäsionsgreifers 20 von oben auf ein Werkstück (nicht eingezeichnet) der Greifkopf 22 etwas nachgeben kann.

Die **Fig. 10** zeigt einen erfindungsgemäßen Elektroadhäsionsgreifer 20, der zusätzlich mit einem Sauggreifer 27 ausgebildet ist (Hybridgreifer).

Der Sauggreifer 27 weist einen glockenartigen Saugkörper 27a auf, an dem eine umlaufende Dichtlippe 28 ausgebildet ist. Über einen Sauganschluss 29 kann ein Saugraum 30, der vom Saugkörper 27a, der Dichtlippe 28 und (nach dem Anlegen an ein Werkstück) von einem anliegenden Werkstück 31' (gestrichelt angedeutet) begrenzt wird, evakuiert werden, um das Werkstück 31' festzuhalten. Die Unterkante der Dichtlippe 28 definiert dabei eine Greiffläche 32' des Sauggreifers 27. Beim Evakuieren wird das Werkstück 31' unter elastischer Verformung der Dichtlippe 28 und gegebenenfalls auch des Saugkörpers 27a nach oben gezogen.

An der werkstückzugewandten, eben ausgebildeten Seite des Saugkörpers 27a ist eine Elektrodenanordnung 25 angebracht (hier aufgeklebt), deren Elektroden (nicht näher dargestellt) über Kabellitzen 26a, 26b mit einer Spannungsquelle bzw. Steuereinrichtung verbunden sind (nicht näher dargestellt). Auf der Elektrodenanordnung 25 ist eine Isolierschicht 33 aufgebracht, um die Elektroden vom Werkstück 31' zuverlässig elektrisch zu trennen und so Kurzschlüsse zwischen den Elektroden zu vermeiden. Auf der Isolierschicht 33 ist hier eine Verschleißschicht 34 aus graphithaltigem Kunststoff aufgebracht, um im industriellen Dauereinsatz einen Abrieb der Isolierschicht 33 zu vermeiden. Die Verschleißschicht 34 kann bei Bedarf oder in regelmäßigen Wartungsintervallen ersetzt werden; durch geeignete Messungen (siehe oben) kann auch ihre verbliebene Dicke VD im Rahmen der Erfindung bestimmt werden.

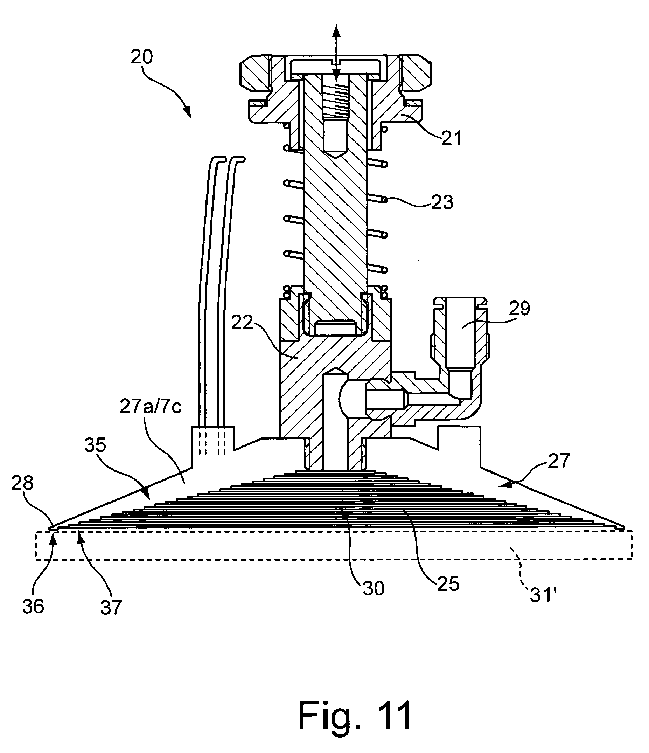

Die Unterseite der Verschleißschicht 34 bildet hier die eigentliche Greiffläche 24 des Elektroadhäsionsgreifers 20 aus; sie wird hier vollständig von der Greiffläche 32' des Sauggreifers 27 überlappt. Dadurch können sich Saug- und Elektroadhäsionsfunktion für das Greifen und Halten von Werkstücken gut unterstützen. Zum Ablegen (Loslassen) eines Werkstücks 31' kann über den Sauganschluss 29 Luft (oder ein anderes Gas) eingeblasen werden, so dass das Werkstück 31 auch gegen Restadhäsionskräfte nach Abschaltung der Elektroadhäsionsspannung schnell und zuverlässig abgelegt werden kann. **Fig. 11** zeigt eine andere Ausführungsform eines erfindungsgemäßen Elektroadhäsionsgreifers 20. Dieser ist ähnlich wie die Ausführungsform von Fig. 9 mit einer Greiferbasis 21 ausgestattet, an der ein gegen eine Feder 23 verschiebbarer Greiferkopf 22 gelagert ist.

Auch dieser Elektroadhäsionsgreifer 20 weist einen zusätzlichen Sauggreifer 27 auf (Hybridgreifer), wobei jedoch dessen Saugkörper 27a insbesondere an seiner werkstückzugewandten Innenseite 35 im Wesentlichen konusmantelförmig (bzw. glockenförmig) ausgebildet ist. An dieser Innenseite 35 ist die Elektrodenanordnung 25 des Elektroadhäsionsgreifers 20 anliegend angebracht, wobei die Elektrodenanordnung 25 hier helixartig verlaufende Elektroden aufweist. Der Saugkörper 27a bzw. dessen Innenseite 35 dient also als Träger 7c für die Elektroden. Der Rand des Saugkörpers 27a bildet eine umlaufende Dichtlippe 28 aus.

Beim Evakuieren des Saugraums 30 wird ein Werkstück 31' nach oben gezogen, wobei sich der Saugkörper 27a elastisch weitet. Dadurch wird der radial äußere Teil 37 der Elektrodenanordnung 25 bzw. der Elektroden (welcher unmittelbar an den Bereich 36 der Dichtlippe 28, der dem Werkstück 31' zugewandt ist, angrenzt) an das Werkstück 31' angedrückt und kann so durch Elektroadhäsion die Dichtwirkung der Dichtlippe 28 unterstützen.

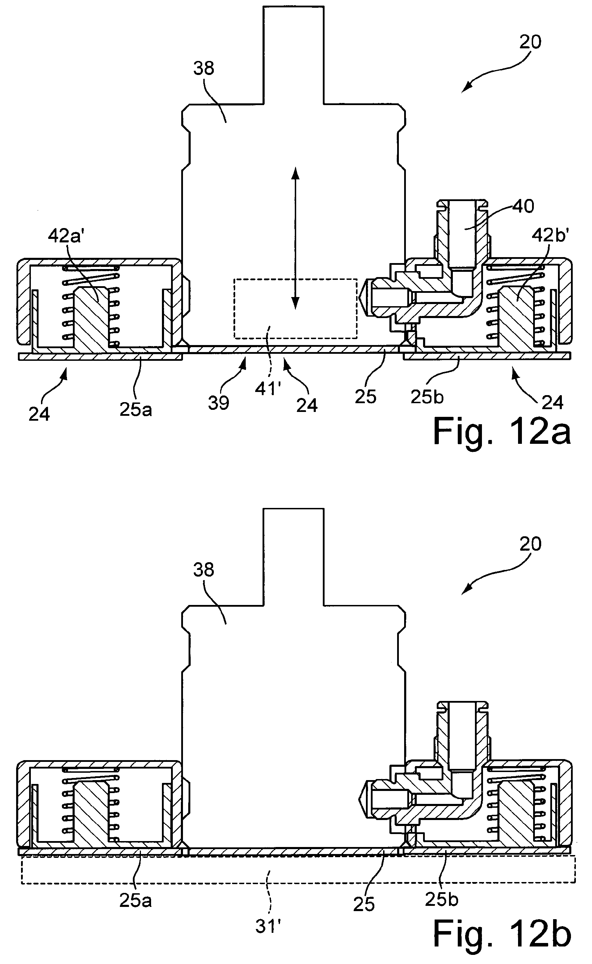

In **Fig. 12a** ist eine weitere Ausführungsform eines erfindungsgemäßen Elektroadhäsionsgreifers 20 gezeigt. Dieser Elektroadhäsionsgreifer 20 weist einen zusätzlichen Magnetgreifer 38 auf (Hybridgreifer), so dass sich deren beide Greiffunktionen gegenseitig unterstützen oder ergänzen können.

Der Magnetgreifer 38 ist mit einem über eine Pneumatik (vgl. Pneumatikstutzen 40) vertikal verfahrbaren Permanentmagneten 41' (gestrichelt angedeutet) ausgestattet. In einer unteren Position des Permanentmagneten 41' (die in Fig. 12a gezeigt ist) ist der Magnetgreifer 38 aktiviert, und ferromagnetische Werkstücke können an die Greiffläche 39 an der Unterseite des Magnetgreifers 38 herangezogen bzw. an dieser gehalten werden. Bei nach oben verfahrenem Permanentmagneten 41' herrscht nur eine geringe Magnetfeldstärke im Bereich der Greiffläche 39, mit vernachlässigbarer Haltewirkung, so dass dann der Magnetgreifer 38 deaktiviert ist.

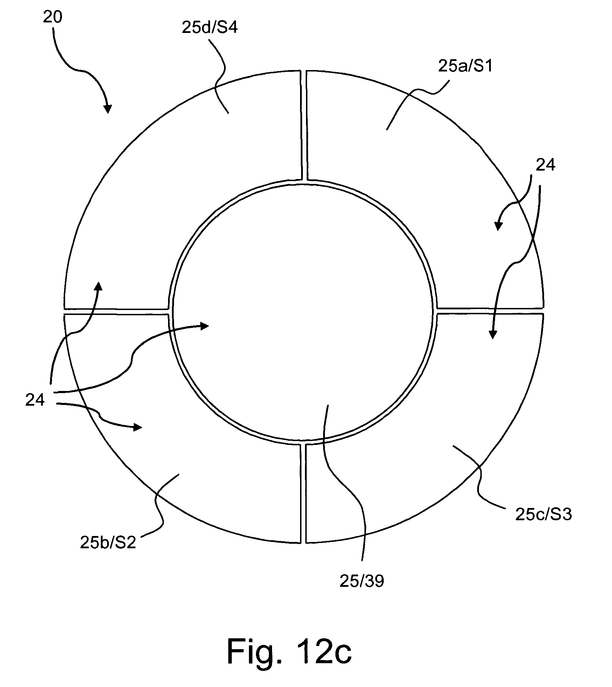

An der Unterseite des Magnetgreifers 38 ist eine erste Elektrodenanordnung 25 ausgebildet, mit der eine Elektroadhäsionsfunktion genutzt werden kann. Weiterhin sind an einzeln gefedert gelagerten Haltern 42a', 42b' weitere Elektrodenanordnungen 25a, 25b ausgebildet, die ebenfalls für eine Elektroadhäsionsfunktion genutzt werden können; in der gezeigten Ausführungsform sind insgesamt vier Halter 42a', 42b' mit Elektrodenanordnungen 25a, 25b vorgesehen, die ringförmig um den Magnetgreifer 38 herum angeordnet sind (vgl. dazu Fig. 12c). Alle Elektrodenanordnungen 25, 25a, 25b bilden zusammen die Greiffläche 24 des Elektroadhäsionsgreifers 20 aus, wobei die Greiffläche 39 des Magnetgreifers 38 und der Teil der Greiffläche 24 des Elektroadhäsionsgreifers 20, der durch die Elektrodenanordnung 25 ausgebildet wird, zusammenfallen, und die Teile der Greiffläche 24, die durch die ringförmig umgebenden Elektrodenanordnungen 25a, 25b ausgebildet werden, an die Greiffläche 39 des Magnetgreifers 38 angrenzen.

Die äußeren Elektrodenanordnungen 25a, 25b stehen gegenüber der Elektrodenanordnung 25 etwas hervor und sind vertikal gegenüber der Elektrodenanordnung 25 beweglich; bevorzugt besteht auch ein merkliches Spiel bezüglich Verkippung. Dadurch können nötigenfalls Krümmungen oder Stufen an der Oberfläche eines ergriffenen Werkstücks 31' ausgeglichen werden. **Fig. 12b** zeigt den Zustand des Elektroadhäsionsgreifers 20 von Fig. 12a mit einem ergriffenen, planaren Werkstück 31'. In diesem Fall werden die Elektrodenanordnungen 25a, 25b auf die gleiche Höhe wie die Elektrodenanordnung 25 verfahren bzw. gedrückt.

**Fig. 12c** zeigt eine unterseitige Ansicht des Elektroadhäsionsgreifers 20 von Fig. 12a. Die Elektrodenanordnung 25 (deren Ausdehnung auch der Greiffläche 39 des Magnetgreifers entspricht) ist ringförmig von den Elektrodenanordnungen 25a-25d umgeben. Alle Elektrodenanordnungen 25, 25a-25d zusammen definieren die Greiffläche 24 des Elektroadhäsionsgreifers 20. Der ringförmige Teil der Greiffläche 24 ist durch die Elektrodenanordnungen 25a-25d in vier Sektoren S1-S4 unterteilt, die über vier Halter einzeln beweglich sind (vgl. Fig. 12a).

Zusammenfassend stellt die Erfindung einen Elektroadhäsionsgreifer vor, bei dem durch Verbinden zweier Elektroden über eine Diode auf einfache Weise eine Greiffunktion und eine Belegungsprüffunktion genutzt werden kann, wobei lediglich zwei elektrische Zuleitungen benötigt werden. Über die Belegungsprüfung kann die Prozesssicherheit der Werkstückhandhabung durch den Elektroadhäsionsgreifer erhöht werden. Der Elektroadhäsionsgreifer kann leicht (auch nachträglich) mit anderen Greiferkonzepten kombiniert werden (Hybridgreifer), insbesondere mit einem Sauggreifer oder einem Magnetgreifer; hierdurch kann eine besonders hohe Haltekraft bereitgestellt werden.

## Patentansprüche

1. Elektroadhäsionsgreifer (20) zum Halten von Werkstücken (31'), umfassend
eine erste spiralförmige Elektrode (1) mit mehreren Windungen und eine zweite spiralförmige Elektrode (2) mit mehreren Windungen, wobei die beiden spiralförmigen Elektroden (1, 2) zumindest teilweise bifilar angeordnet sind,
**dadurch gekennzeichnet,**
**dass** der Elektroadhäsionsgreifer (20) ein Dioden-Bauteil (6) aufweist, über das die spiralförmigen Elektroden (1, 2) miteinander verbunden sind,
wobei die Gesamtheit der über das Dioden-Bauteil (6) in Serie verbundenen Teile der beiden spiralförmigen Elektroden (1, 2) eine nicht verschwindende Induktivität aufweist.

2. Elektroadhäsionsgreifer (20) nach Anspruch 1, **dadurch gekennzeichnet, dass**
das Dioden-Bauteil (6) zwei direkt benachbarte Teilabschnitte (91, 92) der beiden Elektroden (1, 2) miteinander verbindet.

3. Elektroadhäsionsgreifer (20) nach Anspruch 2, **dadurch gekennzeichnet, dass** das Dioden-Bauteil (6) eine von außen gezählt n-te Windung einer der beiden Elektroden (1, 2) mit einer von außen gezählt n+1-ten Windung der anderen Elektrode miteinander verbindet, mit n ∈ IN und n ≥ 1, bevorzugt wobei n = 1.

4. Elektroadhäsionsgreifer (20) nach Anspruch 2, **dadurch gekennzeichnet, dass** die beiden spiralförmigen Elektroden (1, 2) jeweils an ihrem von einem Spannungsanschluss (41, 42) entfernten Ende über das Dioden-Bauteil (6) verbunden sind,
insbesondere wobei die beiden spiralförmigen Elektroden (1, 2) jeweils an ihrem inneren Ende (51, 52) über das Dioden-Bauteil (6) verbunden sind.

5. Elektroadhäsionsgreifer (20) nach einem der Ansprüche 1 bis 3, **dadurch gekennzeichnet, dass** zumindest eine der beiden Elektroden (1, 2) beabstandet von ihrem von einem Spannungsanschluss (41, 42) entfernten Ende mit dem Dioden-Bauteil (6) verbunden ist, insbesondere wobei die andere Elektrode (1, 2) mit ihrem von einem Spannungsabschluss (41, 42) entfernten Ende mit dem Dioden-Bauteil (6) verbunden ist.

6. Elektroadhäsionsgreifer (20) nach einem der vorhergehenden Ansprüche, **dadurch gekennzeichnet, dass** die Anzahl der Windungen der ersten spiralförmigen Elektrode (1) und der zweiten spiralförmigen Elektrode (2), die über das Dioden-Bauteil (6) in Serie miteinander verbunden sind, ungleich ist.

7. Elektroadhäsionsgreifer (20) nach einem der Ansprüche 1 bis 6, **dadurch gekennzeichnet, dass** der radiale Abstand (A, Ai, Aa) der Elektroden (1, 2) dort, wo die Elektroden (1, 2) bifilar angeordnet sind, mit dem Spiralradius (R) konstant bleibt.

8. Elektroadhäsionsgreifer (20) nach einem der Ansprüche 1 bis 6, **dadurch gekennzeichnet, dass** der radiale Abstand (A, Ai, Aa) der Elektroden (1, 2) dort, wo die Elektroden (1, 2) bifilar angeordnet sind, mit dem Spiralradius (R) veränderlich ist.

9. Elektroadhäsionsgreifer (20) nach einem der Ansprüche 1 bis 8, **dadurch gekennzeichnet,**
**dass** die erste spiralförmige Elektrode (1) zumindest im Wesentlichen in einer ersten Ebene verläuft, und die zweite spiralförmige Elektrode (2) zumindest im Wesentlichen in einer zweiten Ebene verläuft,
und **dass** die Ebenen zusammenfallen oder parallel in einem maximalen Abstand (AB) von 3,0 mm, bevorzugt in einem maximalen Abstand (AB) von 2,0 mm, angeordnet sind.

10. Elektroadhäsionsgreifer (20) nach einem der Ansprüche 1 bis 8, **dadurch gekennzeichnet, dass** die beiden spiralförmigen Elektroden (1, 2) an einer im Wesentlichen konusmantelförmigen oder glockenförmigen Innenseite (35) eines gemeinsamen Trägers (7c) angeordnet oder ausgebildet sind und helixartig verlaufen.

11. Elektroadhäsionsgreifer (20) nach einem der vorhergehenden Ansprüche, **dadurch gekennzeichnet, dass** die beiden spiralförmigen Elektroden (1, 2) und das Dioden-Bauteil (6) auf einer selbstklebenden Folie angeordnet sind, die auf einer werkstückzugewandte Seite des Elektroadhäsionsgreifers (20) aufgeklebt ist.

12. Elektroadhäsionsgreifer (20) nach einem der vorhergehenden Ansprüche, **dadurch gekennzeichnet, dass** die beiden Elektroden (1, 2) auf einer werkstückzugewandten Seite von einer Isolierschicht (33) bedeckt sind.

13. Elektrodenadhäsionsgreifer (20) nach Anspruch 12, **dadurch gekennzeichnet, dass** auf einer werkstückzugewandten Seite der Isolierschicht (33) eine Verschleißschicht (34) angeordnet ist, insbesondere wobei die Verschleißschicht (34) aus einem graphithaltigen Kunststoff oder einem mit Metallpartikeln angereicherten Kunststoff besteht.

14. Elektroadhäsionsgreifer (20) nach einem der vorhergehenden Ansprüche, **dadurch gekennzeichnet, dass** am Elektroadhäsionsgreifer (20) zusätzlich ein Sauggreifer (27) ausgebildet ist, wobei der Sauggreifer (27) einen von einem Saugkörper (27a) und einer Dichtlippe (28) begrenzten Saugraum (30) ausbildet,
insbesondere wobei eine Greiffläche (24) des Elektroadhäsionsgreifers (20) und eine Greiffläche (32') des Sauggreifers (27) zumindest teilweise überlappen oder aneinander grenzen.

15. Elektroadhäsionsgreifer (20) nach Anspruch 14, **dadurch gekennzeichnet, dass** zumindest jeweils ein Teil (37) der beiden spiralförmigen Elektroden (1, 2) in einem werkstückzugewandten Bereich (36) der Dichtlippe (28) oder unmittelbar angrenzend an den werkstückzugewandten Bereich (36) der Dichtlippe (28) ausgebildet ist.

16. Elektroadhäsionsgreifer (20) nach Anspruch 14 oder 15, **dadurch gekennzeichnet, dass** jeweils zumindest ein Teil der beiden spiralförmigen Elektroden (1, 2), und bevorzugt auch das Dioden-Bauteil (6), im Bereich einer werkstückzugewandten Seite des Saugkörpers (27a) in den Saugkörper (27a) integriert sind.

17. Elektroadhäsionsgreifer (20) nach einem der vorhergehenden Ansprüche, **dadurch gekennzeichnet, dass** am Elektroadhäsionsgreifer (20) zusätzlich ein Magnetgreifer (38) ausgebildet ist,
insbesondere wobei eine Greiffläche (24) des Elektroadhäsionsgreifers (20) und eine Greiffläche (39) des Magnetgreifers (38) zumindest teilweise überlappen oder aneinander grenzen.

18. Elektroadhäsionsgreifer (20) nach Anspruch 17, **dadurch gekennzeichnet, dass** zumindest ein Teil einer Greiffläche (24) des Elektroadhäsionsgreifers (20) ringförmig um eine Greiffläche (39) des Magnetgreifers (38) angeordnet ist.

19. Elektroadhäsionsgreifer (20) nach Anspruch 18, **dadurch gekennzeichnet, dass** der Teil der Greiffläche (24) des Elektroadhäsionsgreifers (20), der die Greiffläche (39) des Magnetgreifers (38) ringförmig umschließt, gefedert gelagert ist, insbesondere wobei dieser Teil in eine Position vorgespannt ist, in der dieser Teil gegenüber der Greiffläche (39) des Magnetgreifers (38) hervorsteht,
und insbesondere wobei dieser Teil in einzeln bewegliche, gefedert gelagerte Sektoren (S1-S4) unterteilt ist.

20. Verfahren zum Betrieb eines Elektroadhäsionsgreifers (20) nach einem der Ansprüche 1 bis 19, **dadurch gekennzeichnet, dass** zwischen den beiden Elektroden (1, 2) eine Wechselspannung angelegt wird.

21. Verfahren nach Anspruch 20, **dadurch gekennzeichnet, dass** die Wechselspannung eine Amplitude (AMP) in einem Bereich zwischen 1 kV und 20 kV, bevorzugt zwischen 5 kV und 10 kV, aufweist,
und/oder dass die Wechselspannung eine Frequenz in einem Bereich zwischen 500 Hz und 20 kHz, bevorzugt zwischen 1 kHz und 10 kHz, aufweist.

22. Verfahren nach Anspruch 20 oder 21, **dadurch gekennzeichnet, dass** mehrere aufeinanderfolgende Halbwellen (12a-12d, 12e-12f) der Wechselspannung eine gleiche, erste Polarität aufweisen, wobei das Dioden-Bauteil (6) bei dieser ersten Polarität sperrt.

23. Verfahren nach einem der Ansprüche 20 bis 22, **dadurch gekennzeichnet, dass** während einer oder mehrerer aufeinanderfolgender Halbwellen (13) der Wechselspannung mit einer zweiten Polarität, bei der das Dioden-Bauteil (6) leitet, eine Bestimmung der Belegung des Elektroadhäsionsgreifers (20) erfolgt.

24. Verfahren nach einem der Ansprüche 20 bis 23, **dadurch gekennzeichnet, dass** während einer oder mehrerer aufeinanderfolgender Halbwellen (13) der Wechselspannung mit einer zweiten Polarität, bei der das Dioden-Bauteil (6) leitet, eine Bestimmung des Verschleißgrads des Elektroadhäsionsgreifers (20) erfolgt.

25. Verfahren nach einem der Ansprüche 20 bis 24, **dadurch gekennzeichnet, dass** zum Ablegen eines Werkstücks (31') die Wechselspannung zwischen den Elektroden (1, 2) abgeschaltet wird und das Werkstück (31') vom Elektroadhäsionsgreifer (20) abgeblasen wird.

## Claims

1. Electroadhesion gripper (20) for retaining workpieces (31'), comprising
a first spiral electrode (1) having a plurality of turns and a second spiral electrode (2) having a plurality of turns, the two spiral electrodes (1, 2) being arranged so as to be at least partially bifilar,
**characterised in that**
the electroadhesion gripper (20) has a diode component (6) by means of which the spiral electrodes (1, 2) are connected to each other,
wherein the entirety of the portions of the two spiral electrodes (1, 2), which portions are connected in series by means of the diode component (6), has a perceptible inductivity.

2. Electroadhesion gripper (20) according to claim 1, **characterised in that**
the diode component (6) connects to each other two directly neighboring part-portions (91, 92) of the two electrodes (1, 2).

3. Electroadhesion gripper (20) according to claim 2, **characterised in that**
the diode component (6) connects an nth turn of one of the two electrodes (1, 2) when counting from the outer side to an n+1th turn of the other electrode when counting from the outer side, with n ε IN and n ≥ 1, preferably where n = 1.

4. Electroadhesion gripper (20) according to claim 2, **characterised in that**
the two spiral electrodes (1, 2) are connected via the diode component (6) at the end thereof remote from a voltage connection (41, 42) in each case,
in particular with the two spiral electrodes (1, 2) being connected via the diode component (6) at the inner end (51, 52) thereof in each case.

5. Electroadhesion gripper (20) according to any one of claims 1 to 3, **characterised in that** at least one of the two electrodes (1, 2) is connected to the diode component (6) with spacing from the end thereof remote from a voltage connection (41, 42),
in particular with the other electrode (1, 2) being connected to the diode component (6) with the end thereof remote from a voltage connection (41, 42).

6. Electroadhesion gripper (20) according to any one of the preceding claims, **characterised in that** the number of turns of the first spiral electrode (1) and the second spiral electrode (2) which are connected to each other in series by means of the diode component (6) is unequal.

7. Electroadhesion gripper (20) according to any one of claims 1 to 6, **characterised in that** the radial spacing (A, Ai, Aa) of the electrodes (1, 2) remains constant as a function of the spiral radius (R) at the locations where the electrodes (1, 2) are arranged in a bifilar manner.

8. Electroadhesion gripper (20) according to any one of claims 1 to 6, **characterised in that** the radial spacing (A, Ai, Aa) of the electrodes (1, 2) is variable as a function of the spiral radius (R) at locations where the electrodes (1, 2) are arranged in a bifilar manner.

9. Electroadhesion gripper (20) according to any one of claims 1 to 8, **characterised in that**
the first spiral electrode (1) extends at least substantially in a first plane and the second spiral electrode (2) extends at least substantially in a second plane,
and **in that** the planes coincide or are arranged parallel with a maximum spacing (AB) of 3.0 mm, preferably with a maximum spacing (AB) of 2.0 mm.

10. Electroadhesion gripper (20) according to any one of claims 1 to 8, **characterised in that** the two spiral electrodes (1, 2) are arranged or constructed at a substantially cone-outer-like or bell-like inner side (35) of a common carrier (7c) and extend helically.

11. Electroadhesion gripper (20) according to any one of the preceding claims, **characterised in that** the two spiral electrodes (1, 2) and the diode component (6) are arranged on a self-adhesive film which is bonded to a workpiece-facing side of the electroadhesion gripper (20).

12. Electroadhesion gripper (20) according to any one of the preceding claims, **characterised in that** the two electrodes (1, 2) are covered by an insulation layer (33) at a workpiece-facing side.

13. Electroadhesion gripper (20) according to claim 12, **characterised in that** a wear layer (34) is arranged at a workpiece-facing side of the insulation layer (33), in particular with the wear layer (34) comprising a graphite-containing plastics material or a plastics material enriched with metal particles.

14. Electroadhesion gripper (20) according to any one of the preceding claims, **characterised in that** a suction gripper (27) is further constructed on the electroadhesion gripper (20), the suction gripper (27) forming a suction chamber (30) which is delimited by a suction member (27a) and a sealing lip (28), in particular with a gripping face (24) of the electroadhesion gripper (20) and a gripping face (32') of the suction gripper (27) overlapping each other at least partially or abutting each other.

15. Electroadhesion gripper (20) according to claim 14, **characterised in that** at least a portion (37) of the two spiral electrodes (1, 2) in each case is constructed in a workpiece-facing region (36) of the sealing lip (28) or directly adjacent to the workpiece-facing region (36) of the sealing lip (28).

16. Electroadhesion gripper (20) according to claim 14 or 15, **characterised in that** at least a portion of the two spiral electrodes (1, 2) in each case, and preferably also the diode component (6), are integrated in the suction member (27a) in the region of a workpiece-facing side of the suction member (27a).

17. Electroadhesion gripper (20) according to any one of the preceding claims, **characterised in that** a magnetic gripper (38) is further formed on the electroadhesion gripper (20), in particular with a gripping face (24) of the electroadhesion gripper (20) and a gripping face (39) of the magnetic gripper (38) at least partially overlapping or abutting each other.

18. Electroadhesion gripper (20) according to claim 17, **characterised in that** at least a portion of a gripping face (24) of the electroadhesion gripper (20) is arranged in an annular manner around a gripping face (39) of the magnetic gripper (38).

19. Electroadhesion gripper (20) according to claim 18, **characterised in that** the portion of the gripping face (24) of the electroadhesion gripper (20), which portion annularly surrounds the gripping face (39) of the magnetic gripper (38), is resiliently supported,
in particular with that portion being pretensioned into a position, in which that portion protrudes relative to the gripping face (39) of the magnetic gripper (38),
and in particular with that portion being subdivided into individually movable, resiliently supported zones (S1-S4).

20. Method for operating an electroadhesion gripper (20) according to any one of claims 1 to 19, **characterised in that** an alternating-current voltage is applied between the two electrodes (1, 2).

21. Method according to claim 20, **characterised in that** the alternating-current voltage has an amplitude (AMP) in a range between 1 kV and 20 kV, preferably between 5 kV and 10 kV, and/or **in that** the alternating-current voltage has a frequency in a range between 500 Hz and 20 kHz, preferably between 1 kHz and 10 kHz.

22. Method according to claim 20 or 21, **characterised in that** a plurality of successive half-waves (12a-12d, 12e-12f) of the alternating-current voltage have an equal, first polarity, the diode component (6) blocking at this first polarity.

23. Method according to any one of claims 20 to 22, **characterised in that** the occupation of the electroadhesion gripper (20) is determined during one or more successive half-waves (13) of the alternating-current voltage having a second polarity, at which the diode component (6) is conductive.

24. Method according to any one of claims 20 to 23, **characterised in that**, during one or more successive half-waves (13) of the alternating-current voltage at a second polarity, in which the diode component (6) is conductive, the wear degree of the electroadhesion gripper (20) is determined.

25. Method according to any one of claims 20 to 24, **characterised in that** the alternating-current voltage between the electrodes (1, 2) is switched off and the workpiece (31') is blown off the electroadhesion gripper (20) in order to deposit a workpiece (31').

## Revendications

1. Organe de préhension par électroadhésion (20) destiné à maintenir des pièces (31'), comprenant une première électrode (1) en forme de spirale dotée de plusieurs spires et une deuxième électrode (2) en forme de spirale dotée de plusieurs spires, les deux électrodes (1, 2) en forme de spirale étant disposées au moins partiellement de manière bifilaire, **caractérisé en ce**
**que** l'organe de préhension par électroadhésion (20) possède un composant diode (6) par le biais duquel les électrodes (1, 2) en forme de spirale sont reliées l'une à l'autre,
l'ensemble des parties des deux électrodes (1, 2) en forme de spirale qui sont branchées en série par le biais du composant diode (6) possédant une inductance non infiniment petite.

2. Organe de préhension par électroadhésion (20) selon la revendication 1, **caractérisé en ce que** le composant diode (6) relie l'une à l'autre deux portions partielles (91, 92) directement voisines des deux électrodes (1, 2).

3. Organe de préhension par électroadhésion (20) selon la revendication 2, **caractérisé en ce que** le composant diode (6) relie l'une à l'autre une n-ème spire, comptée depuis l'extérieur, de l'une des deux électrodes (1, 2) avec une n+1-ème spire, comptée depuis l'extérieur, de l'autre électrode, avec n ∈ IN et n ≥ 1, de préférence avec n = 1.

4. Organe de préhension par électroadhésion (20) selon la revendication 2, **caractérisé en ce que** les deux électrodes (1, 2) en forme de spirale sont reliées par le biais du composant diode (6) respectivement au niveau de leur extrémité éloignée d'une borne de tension (41, 42), les deux électrodes (1, 2) en forme de spirale étant notamment reliées par le biais du composant diode (6) respectivement au niveau de leur extrémité intérieure (51, 52).

5. Organe de préhension par électroadhésion (20) selon l'une des revendications 1 à 3, **caractérisé en ce qu'**au moins l'une des deux électrodes (1, 2) est reliée au composant diode (6) à distance de son extrémité éloignée d'une borne de tension (41, 42), l'autre électrode (1, 2) étant notamment reliée au composant diode (6) par son extrémité éloignée d'une borne de tension (41, 42).

6. Organe de préhension par électroadhésion (20) selon l'une des revendications précédentes, **caractérisé en ce que** le nombre de spires de la première électrode (1) en forme de spirale et de la deuxième électrode (2) en forme de spirale qui sont reliées en série par le biais du composant diode (6) sont inégaux.

7. Organe de préhension par électroadhésion (20) selon l'une des revendications 1 à 6, **caractérisé en ce que** l'écart radial (A, Ai, Aa) des électrodes (1, 2) là où les électrodes (1, 2) sont disposées de manière bifilaire reste constant avec le rayon de la spirale (R).

8. Organe de préhension par électroadhésion (20) selon l'une des revendications 1 à 6, **caractérisé en ce que** l'écart radial (A, Ai, Aa) des électrodes (1, 2) là où les électrodes (1, 2) sont disposées de manière bifilaire varie avec le rayon de la spirale (R).

9. Organe de préhension par électroadhésion (20) selon l'une des revendications 1 à 8, **caractérisé en ce que** la première électrode (1) en forme de spirale s'étend au moins sensiblement dans un premier plan et la deuxième électrode (2) en forme de spirale s'étend au moins sensiblement dans un deuxième plan, et **en ce que** les plans coïncident ou sont disposés en parallèle à un écart (AB) maximum de 3,0 mm, de préférence à un écart (AB) maximum de 2,0 mm.

10. Organe de préhension par électroadhésion (20) selon l'une des revendications 1 à 8, **caractérisé en ce que** les deux électrodes (1, 2) en forme de spirale sont disposées ou configurées sur un côté intérieur (35) sensiblement en forme d'enveloppe conique ou en forme de cloche d'un support commun (7a) et s'étendent à la manière d'une hélice.

11. Organe de préhension par électroadhésion (20) selon l'une des revendications précédentes, **caractérisé en ce que** les deux électrodes (1, 2) en forme de spirale et le composant diode (6) sont disposés sur un film autoadhésif, lequel est collé sur un côté faisant face à la pièce de l'organe de préhension par électroadhésion (20).

12. Organe de préhension par électroadhésion (20) selon l'une des revendications précédentes, **caractérisé en ce que** les deux électrodes (1, 2) sont recouvertes d'une couche isolante (33) sur un côté faisant face à la pièce.

13. Organe de préhension par électroadhésion (20) selon la revendication 12, **caractérisé en ce qu'**une couche d'usure (34) est disposée sur un côté de la couche isolante (33) faisant face à la pièce, la couche d'usure (34) se composant notamment d'une matière plastique contenant du graphite ou d'une matière plastique enrichie avec des particules métalliques.

14. Organe de préhension par électroadhésion (20) selon l'une des revendications précédentes, **caractérisé en ce qu'**un organe de préhension à ventouse (27) est en plus formé sur l'organe de préhension par électroadhésion (20), l'organe de préhension à ventouse (27) formant un espace d'aspiration (30) délimité par un corps d'aspiration (27a) et une lèvre d'étanchéité (28), une surface de préhension (24) de l'organe de préhension par électroadhésion (20) et une surface de préhension (32') de l'organe de préhension à ventouse (27) se chevauchant ou étant adjacentes notamment au moins partiellement.

15. Organe de préhension par électroadhésion (20) selon la revendication 14, **caractérisé en ce qu'**au moins une partie (37) des deux électrodes (1, 2) en forme de spirale est respectivement formée dans une zone (36) de la lèvre d'étanchéité (28) faisant face à la pièce ou directement adjacente à la zone (36) de la lèvre d'étanchéité (28) faisant face à la pièce.

16. Organe de préhension par électroadhésion (20) selon la revendication 14 ou 15, **caractérisé en ce qu'**au moins une partie des deux électrodes (1, 2) en forme de spirale et de préférence aussi le composant diode (6) sont respectivement intégrés dans le corps d'aspiration (27a) dans la zone d'un côté du corps d'aspiration (27a) faisant face à la pièce.

17. Organe de préhension par électroadhésion (20) selon l'une des revendications précédentes, **caractérisé en ce qu'**un organe de préhension magnétique (38) est en plus formé sur l'organe de préhension par électroadhésion (20), une surface de préhension (24) de l'organe de préhension par électroadhésion (20) et une surface de préhension (39) de l'organe de préhension magnétique (38) se chevauchant ou étant adjacentes notamment au moins partiellement.

18. Organe de préhension par électroadhésion (20) selon la revendication 17, **caractérisé en ce qu'**au moins une partie d'une surface de préhension (24) de l'organe de préhension par électroadhésion (20) est disposée en forme d'anneau autour d'une surface de préhension (39) de l'organe de préhension magnétique (38).

19. Organe de préhension par électroadhésion (20) selon la revendication 18, **caractérisé en ce que** la partie de la surface de préhension (24) de l'organe de préhension par électroadhésion (20) qui entoure la surface de préhension (39) de l'organe de préhension magnétique (38) en forme d'anneau est montée sur ressort, cette partie étant notamment précontrainte dans une position dans laquelle cette partie fait saillie par rapport à la surface de préhension (39) de l'organe de préhension magnétique (38), et cette partie étant notamment divisée en secteurs mobiles montés élastiquement (S1-S4).

20. Procédé pour faire fonctionner un organe de préhension par électroadhésion (20) selon l'une des revendications 1 à 19, **caractérisé en ce qu'**une tension alternative est appliquée entre les deux électrodes (1, 2).

21. Procédé selon la revendication 20, **caractérisé en ce que** la tension alternative présente une amplitude (AMP) dans une plage entre 1 kV et 20 kV, de préférence entre 5 kV et 10 kV, et/ou **en ce que** la tension alternative présente une fréquence dans une plage entre 500 Hz et 20 kHz, de préférence entre 1 kHz et 10 kHz.

22. Procédé selon la revendication 20 ou 21, **caractérisé en ce que** plusieurs demi-ondes successives (12a-12d, 12e-12f) de la tension alternative présentent une première polarité identique, le composant diode (6) étant bloqué à cette première polarité.

23. Procédé selon l'une des revendications 20 à 22, **caractérisé en ce que** pendant une ou plusieurs demi-ondes successives (13) de la tension alternative ayant une deuxième polarité, à laquelle le composant diode (6) est passant, une détermination de l'occupation de l'organe de préhension par électroadhésion (20) est effectuée.

24. Procédé selon l'une des revendications 20 à 23, **caractérisé en ce que** pendant une ou plusieurs demi-ondes successives (13) de la tension alternative ayant une deuxième polarité, à laquelle le composant diode (6) est passant, une détermination du degré d'usure de l'organe de préhension par électroadhésion (20) est effectuée.

25. Procédé selon l'une des revendications 20 à 24, **caractérisé en ce que** pour déposer une pièce (31'), la tension alternative entre les électrodes (1, 2) est déconnectée et la pièce (31') est séparée par soufflage de l'organe de préhension par électroadhésion (20).
